(19) Europäisches Patentamt
European Patent Office
Office européen des brevets

(11) **EP 1 387 178 B1**

(12) **EUROPÄISCHE PATENTSCHRIFT**

(45) Veröffentlichungstag und Bekanntmachung des Hinweises auf die Patenterteilung:
**14.04.2010 Patentblatt 2010/15**

(51) Int Cl.:
*G01R 33/035* (2006.01)

(21) Anmeldenummer: **03017464.3**

(22) Anmeldetag: **01.08.2003**

(54) **SQUID Magnetometer**

SQUID magnetometer

Magnetomètre à SQUID

(84) Benannte Vertragsstaaten:
**AT BE BG CH CY CZ DE DK EE ES FI FR GB GR HU IE IT LI LU MC NL PT RO SE SI SK TR**

(30) Priorität: **02.08.2002 DE 10235633**

(43) Veröffentlichungstag der Anmeldung:
**04.02.2004 Patentblatt 2004/06**

(60) Teilanmeldung:
**06016995.0 / 1 717 593**

(73) Patentinhaber:
• **QEST Quantenelektronische Systeme GmbH**
  **71088 Holzgerlingen (DE)**
• **Institut für Photonische Technologien e.V.**
  **07745 Jena (DE)**

(72) Erfinder:
• **Oppenländer, Jörg**
  **72138 Kirchentellinsfurt (DE)**
• **Zakosarenko, Viatcheslav**
  **07747 Jena (DE)**
• **Schultze, Volkmar**
  **07751 Sulza (DE)**
• **Ijsselsteijn, Rob**
  **07743 Jena (DE)**

(74) Vertreter: **Eisele, Otten, Roth & Dobler**
**Patentanwälte**
**Grosstobeler Strasse 39**
**88276 Ravensburg / Berg (DE)**

(56) Entgegenhaltungen:
**EP-A- 0 926 508      DE-A- 10 043 657**
**US-A- 5 326 986      US-A- 5 548 130**
**US-A- 5 600 242      US-A- 5 955 400**

• **ENPUKU K ET AL: "JOSEPHSON JUNCTION ARRAY FOR THE MEASUREMENT OF HIGH-FREQUENCY MAGNETIC FIELDS" JAPANESE JOURNAL OF APPLIED PHYSICS, PUBLICATION OFFICE JAPANESE JOURNAL OF APPLIED PHYSICS. TOKYO, JP, Bd. 39, Nr. 6A, PART 2, 1. Juni 2000 (2000-06-01), Seiten L510-L513, XP001015011 ISSN: 0021-4922**

**Beschreibung**

Die Erfindung betrifft einen Magnetometer nach dem Oberbegriff des Anspruchs 1.

Stand der Technik

Bislang werden Magnetometer zur hochpräzisen Messung von Magnetfeldern regelmäßig auf der Basis von supraleitenden Quanten-Interferenz-Detektoren (SQUID) aufgebaut. Bei derartigen SQUIDs werden einfach geschlossene supraleitende Stromschlaufen verwendet, welche üblicherweise zwei, in vereinzelten Anwendungen auch mehr Josephsonkontakte enthalten. Sofern diese Stromschlaufen mit einem Strom getrieben werden, der unter einem kritischen Strom liegt, fällt an den Kontakten keine Spannung ab. In der Magnetometer-Anwendung werden die Stromschlaufen jedoch durch einen überkritischen Strom getrieben, so dass zwischen den beiden supraleitenden Elektroden zu beiden Seiten der Kontakte eine sich zeitlich schnell ändernde Wechselspannung abfällt. Die Frequenz dieser Wechselspannung hängt von der Stärke des treibenden Stromes und der Stärke des magnetischen Flusses ab, der die Schlaufe durchsetzt. Als einfach zugängliche Messgröße dient beim Magnetometer die über der Stromschlaufe abfallende Gleichspannung, welche durch zeitliche Mittlung der sich schnell ändernden Wechselspannung über eine oder mehrere Perioden entsteht. Die Eichkurve eines typischen Zwei-Kontakt-DC-QUID besitzt eine Periodizität mit der Periode $\Phi_0$. $\Phi_0$ ist dabei das elementare Flussquant $\Phi_0 = h/2e$. Immer dann, wenn der Fluss, der die Stromschlaufen durchsetzt, einem ganzzahligen Vielfachen des elementaren Flussquants entspricht, nimmt die Eichkurve ein Minimum an, für halbzahlige Vielfache des elementaren Flussquants $\Phi_0$ hingegen ein Maximum. Die Eichkurven derartiger SQUID-Systeme besitzen eine solche Periodizität. In Magnetometern muss bei sich stärker ändernden magnetischen Feldern bei der Messung die Anzahl der Perioden der Eichkurve des SQUID bestimmt werden, die bei einer Änderung des Magnetfeldes durchlaufen werden. Aus der Anzahl der durchlaufenden Perioden lässt sich dann die Größe der Magnetfeldänderung bestimmen. Das Zählen der Periodendurchläufe ist nicht nur schaltungstechnisch vergleichsweise aufwändig, sondern unterliegt auch im Hinblick auf maximal mögliche Änderungen pro Zeiteinheit einer Begrenzung. Denn sofern das Äußere zu messende magnetische Feld zu schnell ansteigt, kann die Zählung außer Tritt geraten, wodurch die Messung nutzlos wird.

Aufgabe und Vorteile der Erfindung

Der Erfindung liegt die Aufgabe zugrunde, ein Magnetometer insbesondere zur hochpräzisen Messung von Magnetfeldern auf der Grundlage von supraleitenden, geschlossenen Schlaufen, die jeweils mehrere Josephsonkontakte beinhalten sowie mit einer Elektronikeinheit bereitzustellen, mit welchen sich eine Magnetfeldänderung im Hinblick auf den Vorrichtungsaufwand vergleichsweise einfacher und insgesamt zuverlässiger bestimmen lässt.

Diese Aufgabe wird durch die Merkmale des Anspruchs 1 gelöst. In den Unteransprüchen sind vorteilhafte und zweckmäßige Weiterbildungen der Erfindung beschrieben.

Die Erfindung geht zunächst von einem Magnetometer, insbesondere zur hochpräzisen Messung von magnetischen Feldern aus, das geschlossene, supraleitende eine Stromschleife bildende Zellen, die jeweils mehrere Josephsonkontakte enthalten sowie eine Elektronikeinheit umfasst. Weiterhin bilden die Zellen einen supraleitenden Quanten-Interferenz-Filter, bei welchem wenigstens drei dieser Zellen supraleitend und/oder nicht supraleitend in Verbindung stehen, die Kontakte der wenigstens drei Zellen derart bestromt werden, dass jeweils über mindestens zwei Kontakte einer Zelle eine zeitveränderliche Spannung abfällt, deren zeitliches Mittel nicht verschwindet, die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass die Spannungsantwortfunktion in Bezug auf den magnetischen Fluss keine Periodizität mit der Periode $\Phi_0$ besitzt, so dass das Frequenzspektrum der Spannungsantwortfunktion in Bezug auf den magnetischen Fluss keinen signifikanten $\Phi_0$-periodischen Anteil besitzt, oder, falls ein diskretes Frequenzspektrum existiert, der Beitrag des $\Phi_0$-periodischen Anteils des diskreten Frequenzspektrums im Vergleich zu den nicht $\Phi_0$-periodischen Anteilen des diskreten Frequenzspektrums nicht dominant ist. Der Kern der Erfindung liegt nun darin, dass eine Elektronikeinheit vorgesehen ist, dass die wenigstens drei Zellen derart, insbesondere geometrisch und hinsichtlich der Kontakte, ausgestaltet sind, dass bei einem vorhandenen magnetischen Feld die in den Zellen fließenden Abschirmströme in der Mehrzahl der wenigstens drei Zellen keinen magnetischen Fluss erzeugen, der größer ist als das elementare magnetische Flussquant $\Phi_0$, dass eine mit der Elektronikeinheit verbundene, insbesondere elektrisch und/oder optisch verbundene und mit dem supraleitenden Quanten-Interferenz-Filter magnetisch gekoppelte, elektrisch leitende Rückkoppelschlaufe vorgesehen ist und dass mittels der Elektronikeinheit in der Rückkoppelschlaufe ein Strom derart einstellbar ist, dass am supraleitenden Quanten-Interferenz-Filter eine von der Elektronikeinheit vorgegebene Spannung abfällt und aus der Größe des durch die Rückkoppelschlaufe fließenden Stroms die Stärke des eingekoppelten magnetischen Feldes bestimmbar ist. Damit das Magnetometer eine ausreichende Empfindlichkeit erzielen kann, muss das von im supraleitenden Quanten-Interferenz-Filter (im Folgenden mit SQIF abgekürzt) fließenden Abschirmströmen erzeugte magnetische Feld beschränkt werden. Der bei Anwesenheit eines äußeren magnetischen Feldes um jede SQIF-Zelle fließende Abschirmstrom darf kein sekundäres magnetisches Feld erzeugen, welches in der Mehrzahl der Schlaufen magnetische Flüsse erzeugt, die größer sind als das elementare magnetische Flussquant $\Phi_0$. Ansonsten könnte der von den Abschirmströmen induzierte magnetische Fluss den vom äußeren zu messenden magnetischen Feld induzierten magnetischen Fluss zu stark abschwächen und der Spannungsabfall über dem SQIF würde stark degradieren.

Um die Degradation zu verhindern, müssen die einzelnen SQIF-Zellen bzw. SQIF-Schlaufen und die Geometrie des gesamten SQIF wegen der Periodizitätseigenschaften der Einzelschlaufen derart ausgelegt werden, dass die bei Anwesenheit eines äußeren magnetischen Feldes fließenden Abschirmströme in der Mehrzahl der SQIF-Schlaufen keinen magnetischen Fluss erzeugen, welcher größer ist als das elementare Flussquant $\Phi_0$.

Die Begrenzung der von den Abschirmströmen erzeugten magnetischen Felder kann dabei auf unterschiedliche Art und Weise erfolgen. Zunächst kann die Geometrie des SQIF, insbesondere die Leitungsführung und die Leiterbreite bzw. der Leiterquerschnitt sowie die Schlaufengröße mit Hilfe der bekannten elektrotechnischen Verfahren derart berechnet werden, dass die Induktivitäten der einzelnen Schlaufen klein genug sind. Da der maximale supraleitende Abschirmstrom durch die Größe des kritischen Stroms, der durch die Josephsonkontakte fließen kann, gegeben ist, kann mit Hilfe der berechneten Induktivitäten der in den einzelnen Schlaufen induzierte magnetische Fluss bestimmt werden. Ist dieser Fluss zu groß, dann kann er entweder durch Veränderung der Geometrie des SQIF bzw. der SQIF-Schlaufen oder durch die Wahl von Josephsonkontakten, welche kleinere kritische Ströme besitzen, entsprechend reduziert werden.

Im Gegensatz zu den bekannten SQUIDs oder den bekannten periodischen Anordnungen von identischen Schlaufen ist es zur Erzielung einer optimalen Leistungsfähigkeit des Magnetometers bei SQIFs jedoch nicht notwendig, dass bei Anwesenheit eines magnetischen Feldes die Abschirmströme in allen Schlaufen einen magnetischen Fluss erzeugen, welcher kleiner ist als das elementare Flussquant $\Phi_0$. Da sich die magnetischen Abschirmfelder in erfindungsgemäßen SQIFs zumindest teilweise gegenseitig aufheben und durch die unterschiedlichen Schlaufengrößen unterschiedliche induktive Kopplungen zwischen den Schlaufen auftreten, hat es sich herausgestellt, dass es ausreichend ist, wenn in der Mehrzahl der Schlaufen kein magnetischer Fluss erzeugt wird, welcher größer ist als das elementare Flussquant $\Phi_0$. In der praktischen Anwendung ist dies ein großer Vorteil von SQIFs gegenüber bekannten Anordnungen, da die effektive Gesamtfläche und damit die Sensitivität des Magnetometers in einfacher Weise stark gesteigert werden kann.

Vorzugsweise umfasst das Magnetometer Auswertemittel, die z.B. im Magnetometer integriert sind, um die Bestimmung des magnetischen Felds auf der Grundlage des durch die Rückkoppelschlaufe fließenden Stromes automatisiert vornehmen zu können. Durch die Verwendung eines supraleitenden Quanten-Interferenz-Filters lässt sich die Elektronikeinheit im Vergleich zu bekannten Auswerteschaltungen bei Magnetometern deutlich einfacher ausgestalten.

Die oben angegebenen allgemeinen Merkmale eines supraleitenden Quanten-Interferenz-Filters und eine Vielzahl von Konkretisierungen sind aus der DE 100 43 657 A1 bekannt. Auf diese deutsche Offenlegungsschrift soll daher ausdrücklich Bezug genommen werden. Hieraus ist nicht nur die oben beschriebene Grundform eines supraleitenden Quanten-Interferenz-Filters (im Folgenden auch mit SQIF bezeichnet) bekannt, sondern auch eine Vielzahl von Weiterbildungen entsprechend den nachstehenden Ausführungen A1) bis A12):

A1) Im Hinblick auf die Periodizität der Spannungsantwortfunktion kann für das SQIF auch der folgende funktionale Ansatz gewählt werden: Dass die wenigstens drei Zellen derart geometrisch unterschiedlich ausgestaltet sind, dass die bei einem vorhandenen magnetischen Feld von den Zellen eingeschlossenen magnetischen Flüsse derart in einem Verhältnis zueinander stehen, dass die Periode der Spannungsantwortfunktion des Netzwerks in Bezug auf den die Netzwerkzellen in ihrer Gesamtheit durchsetzenden magnetischen Fluss größer oder sehr viel größer als der Wert eines elementaren Flussquants ist bzw. die Spannungsantwort keinen $\Phi_0$-periodischen Anteil mehr aufweist. Im Idealfall besitzt die Spannungsantwortfunktion keine Periode mehr, wenn die von den Zellen eingeschlossenen magnetischen Flüsse in keinem rationalen Verhältnis zueinander stehen. Vorzugsweise sind zusätzlich die Flächenunterschiede der einzelnen Zellen vergleichsweise groß. Insbesondere in diesem Fall superpositionieren supraleitend verbundene Zellen in einer Weise, dass die Spannungsantwortfunktion keine Periode mehr aufweist.

Somit werden gezielt unterschiedliche Zellen miteinander verschaltet, was der Fachmann bei herkömmlichen SQUID-Anordnungen immer vermeiden möchte. Dies kommt beispielsweise in der Veröffentlichung von HANSEN, BINSLEV J., LINDELOF P.E.: Static and dynamic interactions between Josephson junctions. In: Reviews of Modern Physics, Vol. 56, No. 3, July 1984, S. 431 - 459; zum Ausdruck. In dieser Veröffentlichung wird auf S. 434, linke Spalte, letzter Absatz sowie folgend auf der rechten Spalte ein System mit identischen Zellen und identischen Kontakten favorisiert und dagegen Unsymmetrien als kontraproduktiv für die Funktion des diesbezüglich beschriebenen SQUIDs eingestuft.

Supraleitende Quanten-Interferenz-Filter zeigen den physikalischen Effekt der multiplen makroskopischen Quanten-Interferenz auf eine Weise, dass die Mehrdeutigkeit der Eichkurven herkömmlicher SQUID-Magnetometer und -Gradiometer beseitigt wird.

In einem supraleitenden Quanten-Interferenz-Filter interferieren die quantenmechanischen Wellenfunktionen, welche den Zustand des supraleitenden Festkörpers beschreiben, derart, dass eine eindeutige makroskopische Eichkurve $\left\langle V(\vec{B}; I_0)\right\rangle$ entsteht. Die Eichkurve $\left\langle V(\vec{B}; I_0)\right\rangle$ des supraleitenden Quanten-Interferenz-Filters besitzt im Idealfall keine Periodizität mit der Periode $\Phi_0$ und ist eine in einem bestimmten Messbereich monoton steigende Funktion des Betrags des äußeren magnetischen Feldes $\vec{B}$ am Ort des SQIF.

Die Eindeutigkeit der Eichkurve und die hohe Empfindlichkeit von supraleitenden Quanten-Interferenz-Filtern erlauben die direkte Messung zeitveränderlicher elektromagnetischer Felder in einem kontinuierlichen Frequenzbereich, dessen untere Schranke bei $v_{ext} \approx 0$ und dessen obere Schranke je nach Art der verwendeten Josephsonkontakte oder weak links zur Zeit bei mehreren hundert GHz bis THz liegt. Dieser gesamte Frequenzbereich ist mit einem einzigen entsprechend ausgelegten supraleitenden Quanten-Interferenz-Filter zugänglich. Bei der Detektion elektromagnetischer Wellen operiert der supraleitende Quanten-Interferenz-Filter simultan als Empfangsantenne, Filter und leistungsfähiger Verstärker. Das Eigenrauschen von geeignet ausgelegten Quanten-Interferenz-Filtern kann dabei um mehrere Größenordnungen kleiner sein als das Eigenrauschen konventioneller SQUID-Magnetometer. Ein weiterer Vorteil gegenüber herkömmlichen Antennen und Filtern liegt dabei unter anderem darin, dass bedingt durch das Messprinzip der Frequenzbereich nicht von der räumlichen Ausdehnung des supraleitenden Quanten-Interferenz-Filters abhängt. Die räumliche Ausdehnung kann lediglich die Empfindlichkeit beeinflussen. Die Herstellung von supraleitenden Quanten-Interferenz-Filtern kann nach bekannten kostengünstigen technischen Verfahren erfolgen, wie sie etwa in der modernen Fertigung konventioneller SQUIDs angewandt werden. Da sich die räumliche Ausdehnung von supraleitenden Quanten-Interferenz-Filtern nicht wesentlich von der räumlichen Ausdehnung konventioneller SQUID-Systeme unterscheiden muss, können die für konventionelle SQUID-Systeme entwickelten Kryotechnologien direkt übernommen werden. Spezielle Entwicklungen auf dem Gebiet der Kryotechnologie sind nicht nötig.

A2) Vorzugsweise sind in einem System aus oben beschriebenen Zellen zumindest für eine Zelle, günstigerweise für den größten Teil der Zellen genau zwei Kontakte pro Zelle vorgesehen, welche supraleitend verbunden und elektrisch parallel geschaltet sind. Durch genau zwei Kontakte lassen sich die soeben beschriebenen Effekte vergleichsweise einfach und gut erreichen.

A3) Die gewünschten Effekte lassen sich jedoch auch in günstiger Weise erzielen, wenn in einer Zelle mehr als zwei Kontakte vorgesehen sind, die supraleitend verbunden und elektrisch parallel geschaltet sind, und zwar in Form einer Serienschaltung von Kontakten, die mit einem Einzelkontakt parallel geschaltet ist, oder in Form von zwei parallel geschalteten Serienschaltungen von Kontakten.

A4) Die erfindungsgemäßen Effekte lassen sich jedoch auch durch Strukturen wenigstens einer Zelle eines Netzwerks erreichen, bei denen neben einer Grundform von mindestens zwei Kontakten, an welchen eine im zeitlichen Mittel nicht verschwindende, zeitveränderliche Spannung abfällt, insbesondere neben einer Grundform von zwei elektrisch parallel geschalteten Kontakten, ein weiterer Kontakt oder mehrere weitere Kontakte vorgesehen sind, welche Kontakte nicht direkt bestromt werden und daher an diesen Kontakten im Mittel keine Spannung abfällt. Die Verbindungen aller Kontakte in den einzelnen Zellen ist dabei weiterhin supraleitend. Solche Ausführungsformen können von Vorteil sein, da durch zusätzliche Kontakte die von einem magnetischen Feld in den einzelnen Zellen induzierten Abschirmströme reduziert werden können. Der Einfluss von Eigen- und Gegeninduktivitäten kann dadurch vermindert werden.

A5) In einer besonders bevorzugten Ausführungsform bilden mehrere Zellen ein Netzwerk oder einen Netzwerkabschnitt, in welchem alle Kontakte elektrisch parallel geschaltet sind, so dass die Kontakte gleich gerichtet bestrombar sind. Insbesondere, wenn in diesem Zusammenhang die Zellen supraleitend miteinander in Verbindung stehen, lassen sich durch eine derartige Anordnung besonders große Empfindlichkeiten für die Messung eines Magnetfeldes erzielen.

A6) Mehrere Zellen oder Netzwerkabschnitte lassen sich vorteilhafterweise jedoch auch elektrisch in Reihe schalten, so dass wiederum die Kontakte im Netzwerk in der gleichen Richtung bestrombar sind. Durch diese Maßnahme kann die Größe des Messsignals erhöht werden, da sich in der Reihenschaltung die Spannungen an den Kontakten addieren.

A7) Eine besonders hohe Empfindlichkeit kann auch durch die Parallelschaltung von Serienanordnungen mehrerer Zellen oder Netzwerkabschnitte erreicht werden. Vorzugsweise sind in dieser Ausführungsform die Netzwerkabschnitte oder Zellen supraleitend verschaltet, insbesondere durch supraleitende twisted-pair-Kabel. Das Auflösungsvermögen von supraleitenden Quanten-Interferenz-Filtern kann dabei bis in den Bereich von aT ($10^{-18}$ Tesla) und darunter reichen. Die Eichkurve bleibt auch für solche Messbereiche eindeutig, so dass absolute quantitative Messungen von extrem kleinen Feldern möglich werden.

A8) Das Netzwerk kann spannungsgetrieben oder stromgetrieben eingesetzt werden.

A9) Um möglichst ideale Josephson-Effekte zu erzielen, wird überdies vorgeschlagen, dass die Kontakte als Punktkontakte ausgeführt sind.

A10) Um die Empfindlichkeit eines SQIF zu erhöhen, kann außerdem die Geometrie der Zellenanordnung derart ausgeführt werden, dass ein magnetisches Übersprechen einer Zelle auf eine benachbarte Zelle aufgrund des durch einen in den Zellen fließenden Stroms hervorgerufenen magnetischen Eigenfeldes reduziert wird.

A11) In einer weiteren bevorzugten Ausgestaltung sind die Zellen des Netzwerkes und/oder Netzwerkabschnitte räumlich, insbesondere räumlich zwei- oder dreidimensional ausgerichtet. Durch diese Maßnahme wird es möglich, zusätzlich zum Betrag des Magnetfeldes einzelne Magnetfeldkomponenten zu bestimmen. Bei einer räumlich dreidimensionalen Anordnung lässt sich somit die Richtung des Magnetfelds messen.

A12) Im Weiteren ist es bevorzugt, wenn der die Kontakte treibende Strom durch ohmsche Widerstände, welche insbesondere als bus-bar-Widerstände ausgeführt sind, eingespeist und/oder wieder abgeführt wird. Denn Messungen haben gezeigt, dass die Einspeisung des treibenden Stroms durch ohmsche Widerstände die Performance des SQIF erheblich verbessern kann.

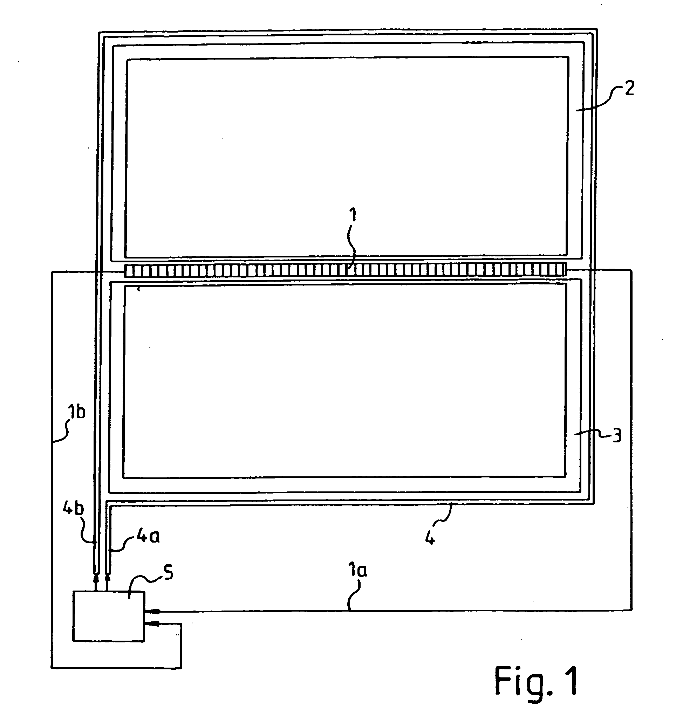

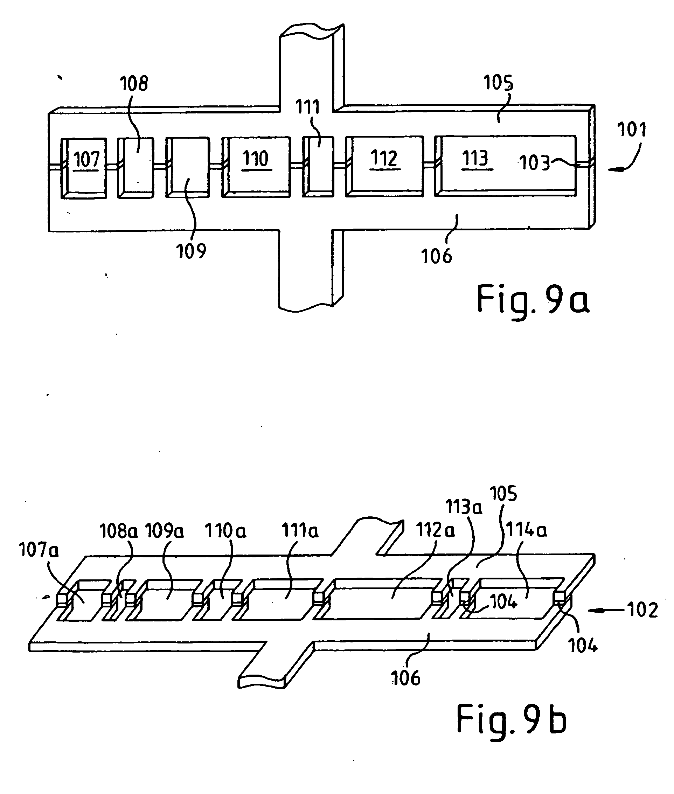

Für weitere Ausgestaltungen von SQIFs wird auf die Figuren 9a bis 20 und deren dazugehörigen Beschreibungsteile im Anschluss an die Figurenbeschreibung zu den Figuren 1 bis 8 verwiesen.

Der Einsatz von einem supraleitenden Quanten-Interferenz-Filter hat im Weiteren den Vorteil, dass derartige Filter einen im Vergleich zu bekannten SQUID größeren Spannungshub besitzen. Hierdurch wird die Gefahr, dass der Messbereich verlassen wird, reduziert. Außerdem wird der Einfluss von Rauschen auf die Messung vermindert. Durch den Einsatz eines supraleitenden Quanten-Interferenz-Filters mit einer eindeutigen Spannungsantwortfunktion lässt sich nach einem Verlassen des Arbeitsbereichs des Magnetometers aufgrund der Eindeutigkeit der ursprüngliche Arbeitspunkt wieder auffinden, wodurch weitere Messungen fehlerfrei an die vorangehenden Messungen anschließen können.

Für ein Magnetometer lassen sich eine Vielzahl von unterschiedlichen Ausgestaltungen eines supraleitenden Quanten-Interferenz-Filters verwenden. Alle supraleitenden Quanten-Interferenz-Filter umfassen, wie bereits oben beschrieben, verschieden große supraleitende Zellen bzw. Schleifen mit mehreren Josephsonkontakten. Einige besonders vorteilhafte hierauf aufgebaute Strukturen von supraleitenden Quanten-Interferenz-Filtern sind nachfolgend beschrieben:

B1) Bei einer ersten Ausführungsform sind die supraleitenden Schleifen in Serie angeordnet. Hierdurch addieren sich die Spannungshübe der einzelnen Schleifen, woraus ein größerer Messbereich um den Arbeitspunkt resultiert. Ein weiterer Vorteil besteht darin, dass das Eigenrauschen der Anordnung gegenüber einer einzelnen Schleife um den Faktor $\sqrt{N}$ verringert wird ($N$ ist gleich die Anzahl der Schleifen). Dies bringt eine entsprechende Verbesserung der rauschbegrenzten Magnetfeldempfindlichkeit. Insbesondere bei hochtemperatursupraleitenden Anordnungen werden sehr kleine kritische Ströme der Josephsonkontakte eingestellt. Dadurch wird gesichert, dass beim verwendeten Betriebsstrom des supraleitenden Quanten-Interferenz-Filters (Betriebsstrom ist gleich der Strom, bei dem ein unikaler Spannungspeak der nicht periodischen Eichkurze am besten ausgeprägt ist) möglichst viele der Einzelschleifen zusammenarbeiten. Dies trägt dem Umstand Rechnung, dass insbesondere bei hochtemperatursupraleitenden Josephsonschaltungen, die kritischen Ströme von mehreren Josephsonkontakten in einem bestimmten Bereich streuen. Bei kleinen kritischen Strömen treten zwei für den Betrieb des supraleitenden Quanten-Interferenz-Filters günstige Umstände auf: Zum einen überlappen die Arbeitsbereiche der einzelnen Kontakte bei gleicher relativer Streuung der kritischen Ströme umso mehr, je kleiner ihre absolute Größe ist. Zum anderen tritt bei kleinen kritischen Strömen eine verstärkte Rauschverrundung auf, welche die Arbeitsbereiche der einzelnen Kontakte noch weiter vergrößert.

B2) Die Schleifen des supraleitenden Quanten-Interferenz-Filters lassen sich auch parallel schalten. Bei gleichem Spannungshub wie bei einer einzelnen Schleife wird hier die Empfindlichkeit gegenüber einem äußeren Magnetfeld entsprechend der Anzahl der Schleifen erhöht. Daraus resultiert eine ebensolche Verringerung des Eigenrauschens im Vergleich zu einer einzelnen Schleife so wie bei der Serienanordnung, wodurch ebenfalls eine entsprechende Verbesserung der rauschbegrenzten Magnetfeldempfindlichkeit erreicht wird. Die Parallelanordnung ist insbesondere auch bei einer Realisierung auf der Grundlage von Hochtemperatursupraleitern vorteilhaft. Im Gegensatz zur Serienanordnung stellen sich die Arbeitspunkte der einzelnen Schleifen automatisch richtig ein, man benötigt also keine gezielte Einstellung niedriger kritischer Ströme. Dies ist deshalb so, weil im Gegensatz zu den kritischen Strömen $I_c$ das Produkt $I_c R_n$ mehrer Josephsonkontakte nur sehr wenig streut. Hierbei ist $R_n$ der Betriebswiderstand des Josephsonkontakts. Bei einer Parallelschaltung von Josephsonkontakten teilt sich der Betriebsstrom umgekehrt proportional zu den Betriebswiderständen auf. Daher erhält jeder Josephsonkontakt den Strom, den er braucht, um in seinem optimalen Arbeitsbereich betrieben werden zu können.

B3) Eine weitere vorteilhafte Ausführungsform besteht in der Kombination einer parallelen und seriellen Anordnung von Schleifen. Diese Anordnung besteht z.B. aus einer Reihenschaltung mehrerer Parallelanordnungen von Schleifen. Vorzugsweise findet sich in der Gesamtanordnung aller Schleifen die gleiche Schleifenverteilung wie bei der reinen Serien- oder Parallelanordnung wieder. Die parallel-serielle Anordnung vereint die Vorteile einer Reihen- und Parallelschaltung. Die Parallelschleifen sichern die Einstellung des optimalen Betriebsstromes für alle Schleifen, aus der Serienanordnung resultiert ein größerer Spannungshub. Die Verbesserung der rauschbegrenzten Magnetfeldempfindlichkeit tritt auch hier ein. Die parallel-serielle Anordnung hat noch einen weiteren Vorteil in der praktischen Anwendung. Durch geeignete Wahl der Zahl von Schleifen in der Parallelanordnung und in Reihe geschalteter solcher Parallelanordnungen kann man den Gesamtbetriebswiderstand des supraleitenden Quanten-Interferenz-Filters einstellen, so dass er an eine äußere Elektronik angepasst werden kann.

Bei einer weiteren besonders bevorzugten Ausgestaltung eines Magnetometers ist in der Rückkoppelschleife ein Strom einstellbar, der im supraleitenden Quanten-Interferenz-Filter einen magnetischen Fluss erzeugt, dessen Betrag mindestens dem Betrag des magnetischen Flusses entspricht, der durch ein von außen in den supraleitenden Quanten-Interferenz-Filter eingekoppeltes magnetisches Feld erzeugt wird. Hierdurch wird es möglich, den supraleitenden Quanten-Interferenz-Filter unabhängig vom zu messenden äußeren magnetischen Feld immer im Arbeitspunkt zu betreiben. In diesem Zusammenhang ist es insbesondere vorteilhaft, wenn die Elektronikeinheit für die Realisierung einer Suchfunktion Mittel zur Einstellung des durch den Strom in der Rückkoppelschleife erzeugten magnetischen Felds umfasst, wobei das magnetische Feld derart veränderbar ist, dass der im Operationsbereich liegende Arbeitspunkt des supraleitenden Quanten-Interferenz-Filters automatisch auffindbar ist. Es geht also darum, unabhängig von der Größe des zu messenden Felds möglichst schnell den Arbeitspunkt des supraleitenden Quanten-Interferenz-Filters einzustellen, um hieraus das zu messende Feld dann bestimmen zu können.
Hierfür kann die Elektronikeinheit in unterschiedlicher Weise ausgeführt werden. Beispielsweise ist es vorteilhaft, wenn die Mittel zur Einstellung des magnetischen Felds eine vergleichsweise schnell durchfahrbare Rampe für den Strom durch die Rückkoppelschlaufe umfassen. Eine derartige Rampe kann im Bereich von Nanosekunden durchfahren werden, wodurch sich die Bestimmung des magnetischen Feldes entsprechend schnell realisieren lässt. Die Rampe lässt sich beispielsweise so einstellen, dass das über den Strom in der Rückkoppelschleife sich ausbildende Referenzmagnetfeld immer bei Startwerten deutlich unterhalb des letzten Messwertes beginnt und dann hoch gefahren wird. Dieser Vorgang endet, sobald am supraleitenden Quanten-Interferenz-Filter eine vorgegebene Spannung abfällt. Z.B. kann auch darauf geregelt werden, dass das Referenzmagnetfeld mit dem zu messenden Magnetfeld übereinstimmt.
Um die Empfindlichkeit des Magnetometers gegenüber äußeren Magnetfeldern zu verbessern, wird im Weiteren vorgeschlagen, dass zur Einkopplung des zu messenden magnetischen Feldes von außen in den supraleitenden Quanten-Interferenz-Filter zusätzliche supraleitende Strukturen vorgesehen sind. Dies kann dadurch erfolgen, dass ein möglichst großer Bereich der geometrisch zur Verfügung stehenden Fläche mit supraleitendem Material ausgefüllt und/oder in diesem Bereich supraleitende Schleifen angeordnet werden. Die zusätzlichen supraleitenden Strukturen können galvanisch unmittelbar mit dem supraleitenden Quanten-Interferenz-Filter verbunden sein. Eine Kopplung kann jedoch auch induktiv stattfinden.
Bei einer weiteren besonders vorteilhaften Ausführungsform der Erfindung sind die zusätzlichen supraleitenden Strukturen derart ausgelegt, dass sie das einzukoppelnde Feld fokussieren. Dies kann beispielsweise durch eine supraleitende Fläche oder eine supraleitende Schleife realisiert werden, die im Bereich des supraleitenden Quanten-Interferenz-Filters angeordnet wird, so dass das durch den Strom in den zusätzlichen Strukturen erzeugte magnetische Feld in den supraleitenden Quanten-Interferenz-Filter einkoppeln kann.
In einer außerdem vorteilhaften Ausgestaltung der Erfindung sind der supraleitende Quanten-Interferenz-Filter und die zusätzliche supraleitende Einkoppelstruktur auf separaten Trägern bzw. Substraten angeordnet, die magnetisch und/oder elektrisch gekoppelt sind. Ein derartiger Aufbau ist in technologischer Hinsicht einfacher, da bei der Herstellung die einzelnen Substrate getrennt behandelt werden können und erst nach Fertigstellung ein Zusammenfügen stattfindet.

Die magnetische Kopplung der separaten Träger kann besonders effektiv durch einen Flusstransformator erfolgen, durch welchen eine weitere Erhöhung der Empfindlichkeit ermöglicht wird.

Um einen kompakten Aufbau zu erhalten, ist es auch vorteilhaft, wenn der supraleitende Quanten-Interferenz-Filter auf der Oberseite eines ersten Trägers und eine flussfokussierende Struktur auf der Unterseite eines zweiten Trägers aufgebracht ist und beide Träger übereinander liegen.

Bei einer wesentlichen Ausführungsform der Erfindung sind Mittel auf der Basis einer supraleitenden Struktur vorgesehen, mit welchen eine oder mehrere räumliche Ableitungen eines zu messenden magnetischen Feldes in den supraleitenden Quanten-Interferenz-Filter einkoppelbar sind. Auf diese Weise wird es möglich, z.B. den Gradienten des Magnetfelds zu bestimmen. Hierzu wird beispielsweise der supraleitende Quanten-Interferenz-Filter induktiv an eine Antenne angekoppelt, wobei die Antenne die Form zweier über einen Mittelsteg verbundener Schleifen (zwei Aufnahmeschleifen sind parallel geschaltet) oder die Form einer 8 (zwei Aufnahmeschlaufen sind in Serie geschaltet) haben kann.

Zur Messung von Magnetfeldgradienten werden in beiden Fällen anstelle zweier separater Antennenschleifen, die auf zwei Seiten induktiv oder direkt an einen supraleitenden Quanten-Interferenz-Filter angekoppelt sind, zwei zu einer einzigen Schleife verbundene Teilschleifen verwendet. Am jeweiligen Mittelsteg lässt sich dann ein supraleitender Quanten-Interferenz-Filter anordnen, der dadurch den Differenzstrom in den Teilschleifen, also das Gradientensignal misst.

In einer überdies bevorzugten Ausgestaltung der Erfindung enthält der Magnetometer mehrere supraleitende Quanten-Interferenz-Filter, welche einzeln oder in Gruppen von einer einzelnen oder mehreren Elektronikeinheiten und durch eine einzelne oder mehrere Rückkoppelschlaufen getrennt oder gemeinsam steuerbar sind. Es sind also eine Vielzahl von Strukturvarianten möglich, mit welchen sich ein Präzisionsmagnetometer aufbauen lässt.

Mehrere Ausführungsbeispiele der Erfindung sind in den Zeichnungen dargestellt und unter Angabe weiterer Vorteile und Einzelheiten näher erläutert.

Es zeigen

Fig. 1          eine schematische Darstellung einer Magnetometer-Anordnung umfassend einen supraleitenden Quanten-InterferenzFilter mit zwei Einkoppelschlaufen in einer Draufsicht,

Fig. 2          eine zu Fig. 1 entsprechende Anordnung, jedoch mit Einkoppelflächen,

Fig. 3          eine schematische Anordnung in Draufsicht mit einer Vielzahl von supraleitenden Quanten-InterferenzFiltern,

Fig. 4          eine schematische Anordnung in Draufsicht, bei welcher der supraleitende Quanten-InterferenzFilter galvanisch mit Einkoppelantennen verbunden ist,

Fig. 5          eine schematische Anordnung in Draufsicht mit supraleitendem QuantenInterferenz-Filter, in den über einen Flusstransformator das Magnetfeld eingekoppelt wird,

Fig. 6a bzw. 6b     eine schematische Anordnung eines supraleitenden Quanten-InterferenzFilters mit Flusstransformator auf zwei Substraten in einer perspektivischen Ansicht mit getrennten Substraten (Fig. 6a) sowie zusammengefügten Substraten (Fig. 6b),

Fig. 7          eine schematische Anordnung in Draufsicht mit einem supraleitenden Quanten-Interferenz-Filter und einem Flusstransformator zur Messung eines Feldgradienten,

Fig. 8          die schematische Darstellung von Schleifen eines supraleitenden Quanten-Interferenz-Filters, die zur Messung von Feldgradienten ausgelegt sind,

Fig. 9a und b     ein mehrzelliges SQIF aus parallel geschalteten Josephsonkontakten in räumlicher Darstellung,

Fig. 10         das Schaltbild eines äquivalenten supraleitenden Stromkreises eines Quanten-Interferenz-Filters mit $N$ = 10 Kontakten,

Fig. 10a bis f     Schaltbilder von weiteren supraleitenden Stromkreisen,

Fig. 11         eine Spannungsantwortfunktion für einen SQIF mit $N$ = 30 Kontakten,

Fig. 12a und b       periodische Spannungsantwortfunktionen für herkömmliche SQUIDs,

Fig. 12c       die Spannungsantwortfunktion eines supraleitenden Quanten-InterferenzFilters,

Fig. 12d       die Spannungsantwortfunktion eines SQUID und eines SQIF,

Fig. 13       eine symbolisch dargestellte räumliche Anordnung eines supraleitenden Quanten-InterferenzFilters mit angedeuteter vektorieller Basis des dreidimensionalen Raumes,

Fig. 14       ein schematisch dargestelltes, ebenes supraleitendes Quanten-InterferenzFilter mit einer Magnetfeldkompensationseinrichtung,

Fig. 15       ein supraleitendes QuantenInterferenz-Filter mit einer parallel geschalteten Steuerleitung in schematischer Ansicht,

Fig. 16       eine schematisch dargestellte Vernetzung von SQIF-Abschnitten,

Fig. 17a bis c       schematisch dargestellte, ebene, supraleitende Quanten-InterferenzFilter mit einer geometrischen Anordnung zur Minimierung des Einflusses von Eigenfeldern,

Fig. 18a       ein Netzwerk aus in Serie geschalteten Zellen,

Fig. 18b       eine zu einem Netzwerk gemäß Fig. 18a entsprechende Spannungsantwortfunktion bei einer Serienschaltung für $N$ = 100 Zellen,

Fig. 18c       eine Stromspannungskennlinie eines Netzwerks gemäß Fig. 18a, wenn es als Stromverstärker mit Hilfe eines Kompensationsstromkreises betrieben wird,

Fig. 19a       im oberen Bild die typische Spannungsantwortfunktion eines herkömmlichen SQUID mit dem zugehörigen Frequenzspektrum im unteren Bild,

Fig. 19b       im oberen Bild eine typische Spannungsantwortfunktion eines Netzwerks aus identischen Zellen und das zugehörige Frequenzspektrum im unteren Bild,

Fig. 19c       im oberen Bild die Spannungsantwortfunktion eines supraleitenden Quanten-InterferenzFilters ohne Periodizität und das dazugehörige Spektrum im unteren Bild,

Fig. 19d       im oberen Bild eine Spannungsantwortfunktion und im unteren Bild das zugehörige Spektrum eines Quanten-Interferenz-Filters, welcher eine technisch bedingte, vergleichsweise große Periodizität besitzt und

Fig. 20       ein schematisch dargestelltes, ebenes supraleitendes Quanten-InterferenzFilter mit einer das primäre magnetische Feld am Ort des Filters verstärkenden supraleitenden Einkoppelschlaufe (pick-up-loop).

Beschreibung der Ausführungsbeispiele

In Fig. 1 ist schematisch ein supraleitender Quanten-Interferenz-Filter 1 (nachstehend auch mit SQIF bezeichnet) mit zwei symmetrisch angeordneten, supraleitenden Einkoppelschlaufen 2, 3 sowie einer um diese Anordnung herumgeführte Stromschlaufe 4 dargestellt. In der Stromschlaufe 4 kann über eine Rückkoppelschaltung 5 ein Rückkoppelfeld erzeugt werden. Hierzu ist die Rückkoppelschlaufe 4 über Verbindungsleitungen 4a, 4b mit der Rückkoppelschaltung 5 verbunden. Außerdem ist die Rückkoppelschaltung über elektrische Leitungen 1a und 1b elektrisch mit dem supraleitenden Quanten-Interferenz-Filter 1 verbunden.
Bei Anwesenheit eines magnetischen Feldes fließt durch die Einkoppelschlaufen 2, 3, die als Magnetfeldantennen wirken, ein supraleitender Abschirmstrom, der am Ort des SQIF 1 ein verstärktes Magnetfeld erzeugt. Entlang des SQIF haben für eine wirksame induktive Einkopplung die Einkoppelschlaufen 2, 3 einen vergleichsweise dünnen Leitungsquerschnitt. Sie sind aber nicht galvanisch mit dem SQIF verbunden.
Bei Anwesenheit eines magnetischen Feldes, das dann auf den SQIF eingekoppelt wird, findet eine Änderung des Spannungsabfalls am SQIF statt. Der Spannungsabfall am SQIF wird in die elektronische Rückkoppelschaltung 5 über die Leitungen 1a, 1b eingespeist. Diese treibt in der Rückkoppel-Stromschlaufe 4 einen Strom in einer solchen Stärke, dass die Änderung des Spannungsabfalls am SQIF wieder aufgehoben wird. Die Stärke des eingespeisten Stroms ist dann direkt proportional mit der Stärke des anliegenden Feldes.

Die Einkoppelschlaufen sind im Bereich des SQIF nicht nur im Leitungsquerschnitt dünner ausgeführt, sondern liegen auch dicht am SQIF.

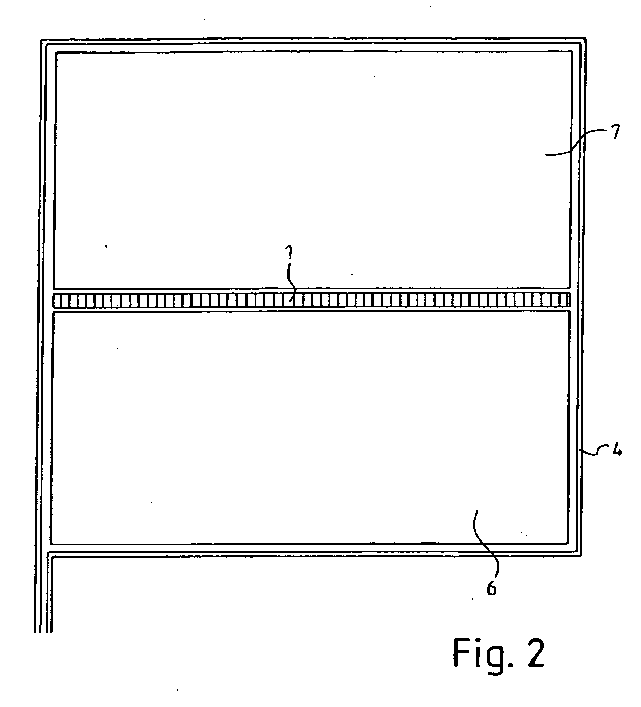

Fig. 2 entspricht im Wesentlichen dem Aufbau von Fig. 1 bis auf die Ausgestaltung der Einkoppelschlaufen, wenn auch einzelne Elemente in Fig. 2 nicht dargestellt sind. Anstatt der Einkoppelschlaufen sind in Fig. 2 flussfokussierende supraleitende Einkoppelflächen 6, 7 ausgebildet. In Anwesenheit eines magnetischen Felds fließt ein Abschirmstrom entlang der Umrandung der Flächen 6, 7. Dieser Abschirmstrom erzeugt im SQIF ein magnetisches Feld. Die Einkoppelflächen 6, 7 wirken wie die Einkoppelschlaufen 2, 3 flussfokussierend, d.h. sie verstärken ein zu messendes außen anliegendes Magnetfeld in einem definierten Bereich.

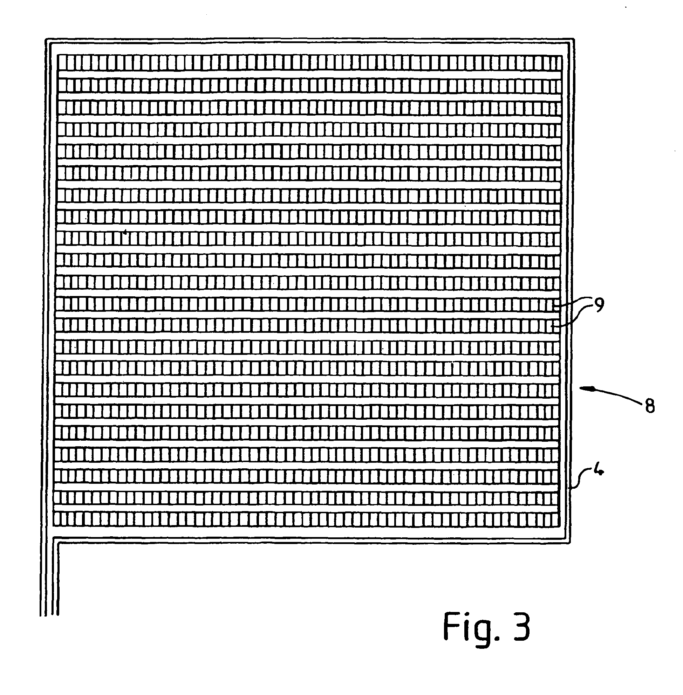

In Fig. 3 sind wesentliche Elemente eines weiteren Magnetometers 8 dargestellt. Hierbei schließt eine Rückkoppel-Stromschlaufe 4 eine Vielzahl von in Serie geschalteten SQIFs ein. Dabei ist die gesamte innerhalb der Rückkoppelschlaufe zur Verfügung stehende Fläche mit SQIFs ausgefüllt. Die SQIFs müssen nicht zwangsläufig in Serie angeordnet werden. Die SQIFs können auch in einer Vielzahl von anderen Schaltungsarten in der Schlaufenfläche platziert werden. Prinzipiell kann auch lediglich ein SQIF in der Schlaufenfläche untergebracht werden. Ein teilweises Bedecken der Schlaufenfläche mit SQIF-Strukturen ist ebenfalls möglich. Für die Messempfindlichkeit ist es jedoch sinnvoll, dass die Schlaufenfläche vollständig ausgefüllt wird. Diese Ausführungsformen ohne flussfokussierende supraleitende Elemente sind nicht hysteretisch, weshalb sie sich für die Absolutmessung von Magnetfeldern eignen. Zur Einstellung des Stromes in der Rückkoppel-Stromschlaufe 4 und einer Arbeitsspannung in den SQIFs kann eine Beschaltung so wie in der Ausführungsform gemäß Fig. 1 zur Anwendung kommen.

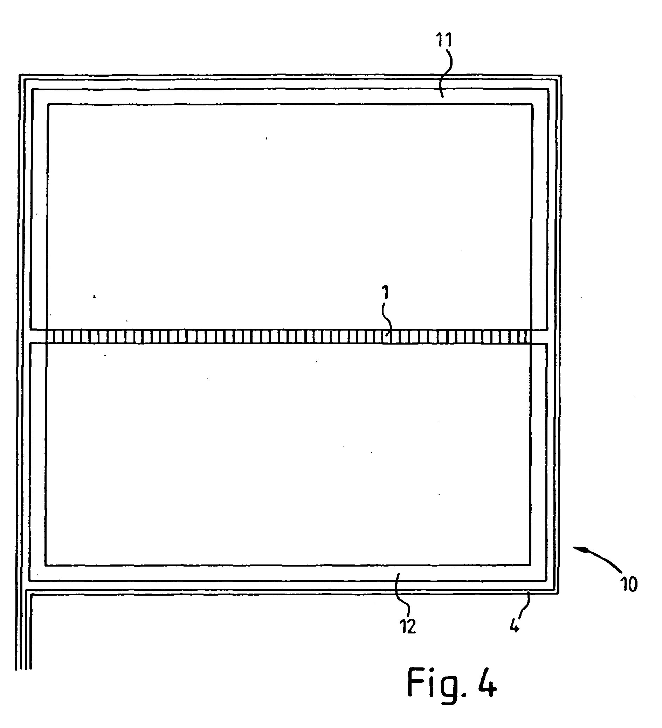

Fig. 4 zeigt ausschnittsweise ein Magnetometer 10, bei welchem innerhalb der Rückkoppel-Stromschlaufe 4 ein SQIF 1 vorgesehen ist, das unmittelbar mit supraleitenden Magnetfeldantennen 11, 12 gekoppelt ist. Eine derartige Anordnung ist insbesondere bei einem SQIF aus parallelgeschalteten Josephsonschlaufen problemlos möglich.

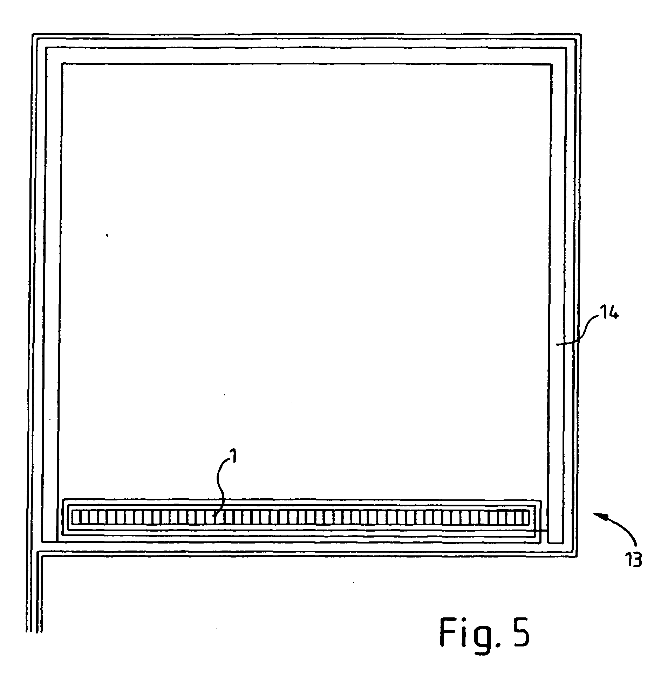

In Fig. 5 ist ein Teil eines Magnetometers 13 abgebildet, bei welchem eine supraleitende Magnetfeldantenne 14 als Flusstransformator ausgelegt ist. Dabei ist die Magnetfeldantenne 14 im Bereich des SQIF 1 mehrfach um den SQIF spiralförmig herumgeführt. Damit wird das durch den in der Magnetfeldantenne 14 bei einem vorhandenen Magnetfeld fließenden Abschirmstrom am Ort des SQIF erzeugte Magnetfeld erheblich verstärkt. Aufgrund dessen, dass bei dieser Spiralanordnung der Einkoppelantenne 14 Überkreuzungen notwendig sind, ist im Hinblick auf die Zahl der supraleitenden Lagen eine Zweilagentechnik erforderlich.

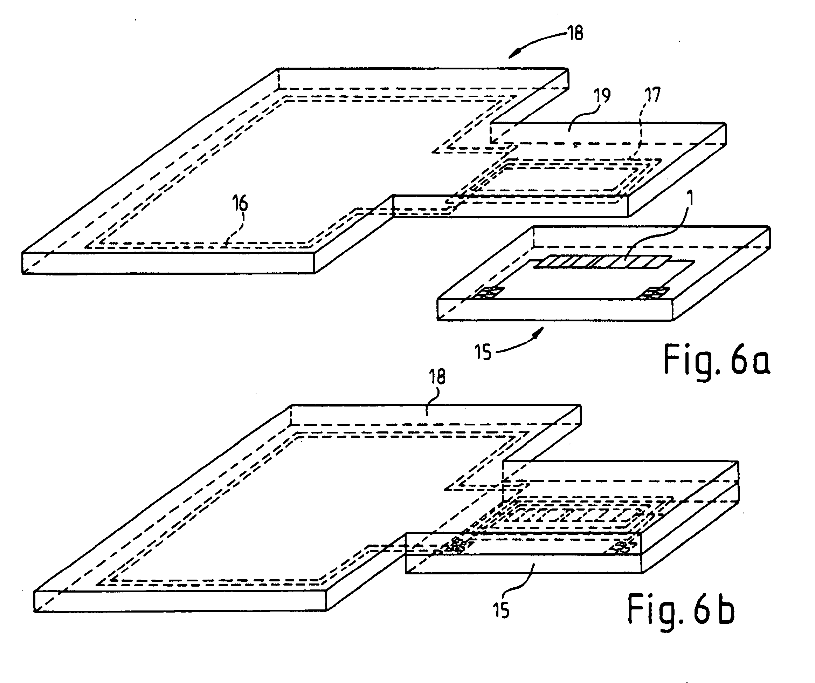

Die Herstellung von SQIF-Strukturen mit Flusstransformator lässt sich vereinfachen, wenn, wie in Fig. 6a dargestellt, das SQIF 1 auf einem ersten Träger 15, z.B. auf der Oberseite und eine flussfokussierende supraleitende Struktur in Form einer Magnetfeldantenne 16 und einer anschließenden Spule 17 zur Ausbildung eines Flusstransformators 18 auf der Unterseite eines zweiten Trägers 19 angeordnet sind.

Die beiden Träger 15, 18 müssen dann lediglich, wie in Fig. 6b gezeigt, übereinandergelegt und durch ein geeignetes Verfahren miteinander verbunden werden.

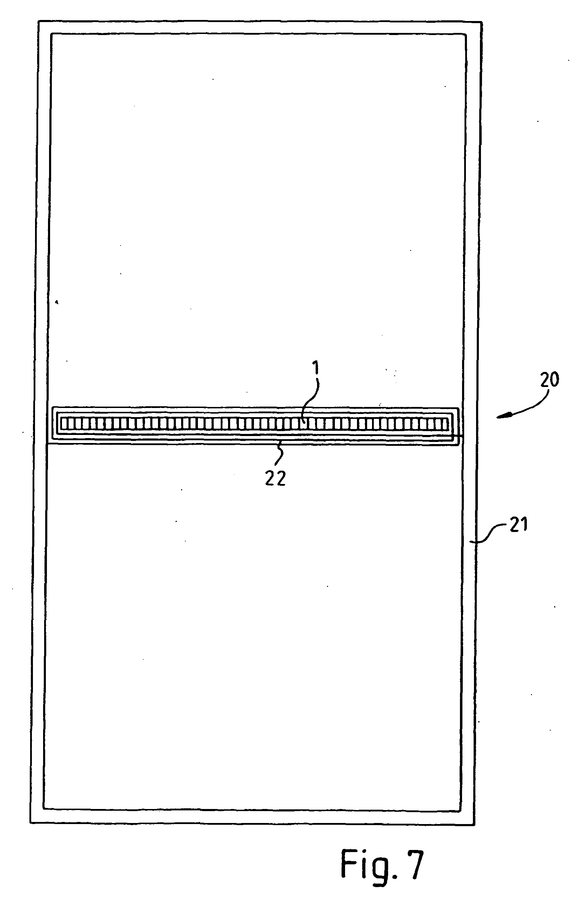

In Fig. 7 ist ein Magnetometer 20 dargestellt, das eine flussfokussierende Magnetfeldantenne 21 umfasst, die als Gradiometerschlaufe ausgelegt ist. Das heißt, die Schlaufe ist an einer Stelle getwistet. Der SQIF liegt zum Beispiel gemäß Fig. 7 im Zentrum einer getwisteten Spule 22. Im Fall eines homogenen Feldes fließt durch die getwistete Spule kein Abschirmstrom, da wegen des Twists der Fluss durch die Schlaufe verschwindet. Dies gilt jedoch nur, wenn die Flächen der hierdurch abstrakt gesehen, ausgebildeten "8" identisch sind. Besitzt das Feld einen Gradienten, dann verschwindet der Fluss nicht und es fließt ein Abschirmstrom, der im Bereich des SQIF ein Magnetfeld erzeugt. Sowohl diese Struktur gemäß Fig. 7 als auch die Struktur gemäß Fig. 6a und 6b werden bevorzugt wie in den vorangegangenen Ausführungsformen, wenn auch nicht dargestellt, mit einer Rückkoppelstromschlaufe mit entsprechender Beschaltung kombiniert.

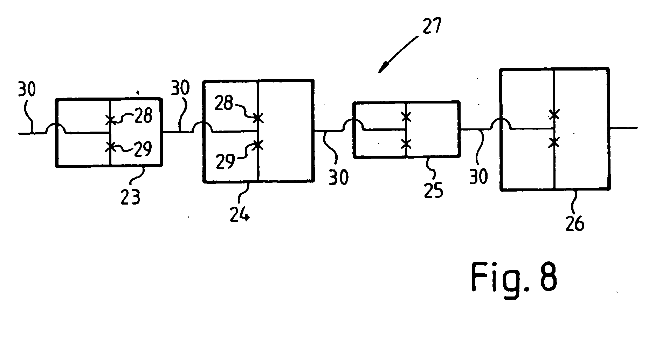

Bei einer weiteren besonders bevorzugten Ausführungsform der Erfindung sind, wie in Fig. 8 dargestellt, einzelne, hier beispielhaft alle Schlaufen 23 bis 26 eines SQIF 27 selbst als Gradiometerschlaufen ausgeführt. Bei homogenem magnetischen Feld fließt durch die Josephsonkontakte 28, 29 des magnetischen Felds kein Abschirmstrom, d.h. der Spannungsabfall am SQIF ändert sich nicht. Bei einem Feldgradienten fließen Abschirmströme, wodurch eine Spannungsänderung am SQIF 27 auftritt, die proportional zum anliegenden Feldgradienten ist. Die einzelnen Schlaufen 22, 26 sind über Leitungen 30 miteinander verbunden, um den SQIF 27 auszubilden.

Die in Fig. 9 skizzierten Ausführungsbeispiele für einen SQIF werden im Folgenden näher erläutert. Die Abbildungen gemäß Fig. 9a und 9b zeigen die physikalischen Realisierungen von einfachen Mehrschlaufen-Netzwerken 101, 102 mit Josephsonkontakten 103, 104, deren Geometrie und Detektionsverhalten supraleitende Quanten-Interferenz-Filter konstituieren. Die Netzwerke 101, 102 bestehen aus supraleitenden Bereichen 105, 106, die durch die Josephsonkontakte 103, 104 miteinander verbunden sind. Die supraleitenden Bereiche können dabei sowohl aus tieftemperatur-supraleitenden Materialen als auch aus hochtemperatur-supraleitenden Materialien bestehen. Auch von der speziellen Ausführung der Josephsonkontakte (z.B. breakjunctions, step-junctions, Mikrobrücken etc.) hängt die Funktionsfähigkeit des Netzwerks nicht ab. Die quantitativen Angaben zu den Ausführungsbeispielen beziehen sich beispielhaft auf die Parameterspezifikationen der dem Stand der Technik entsprechenden typischen Josephsonkontakte aus konventionellen Supraleitern, zum Beispiel solche mit der $Nb|AlO_x|Nb$-Technologie hergestellten Josephsonkontakten, wie sie in herkömmlichen SQUID-Magnetometer zum Einsatz kommen. Solche Kontakte besitzen typische kritische Ströme $i_c$ von etwa 200 $\mu A$ und einen Normalwiderstand $r_n$, der durch einen extern parallelgeschalteten Ohmschen Widerstand definiert ist von z.B. etwa 1Ω, sowie eine geometrische shunt-Kapazität $c_n$ im Bereich von Pikofarad. Die räumliche Ausdehnung des Netzwerks kann vergleichbar mit der herkömmlicher SQUIDs sein. Die Abmessungen der Zellen der Netzwerke liegen dann im Bereich von $\mu$m bis mm. SQIF-Netzwerke können je nach Anwendung aber auch Zellen mit größeren oder kleineren Abmessungen aufweisen.

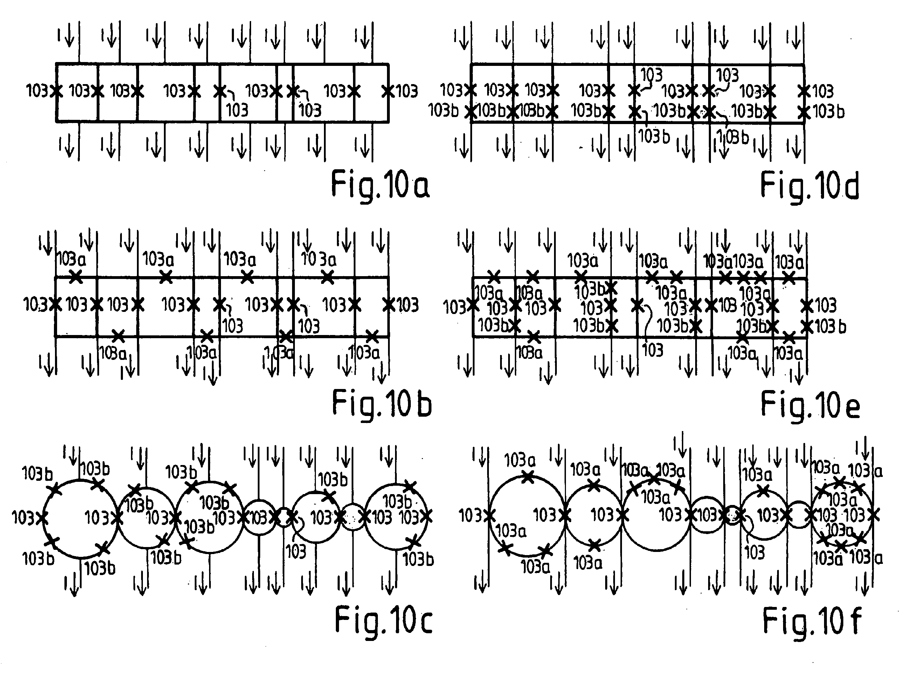

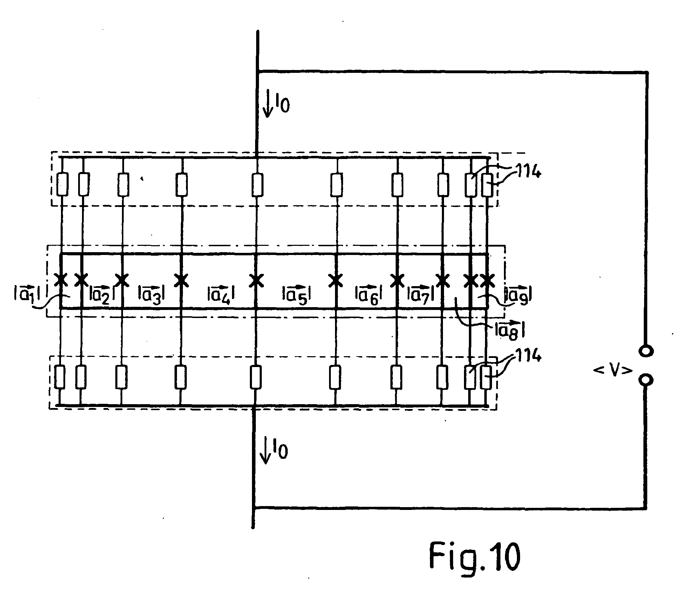

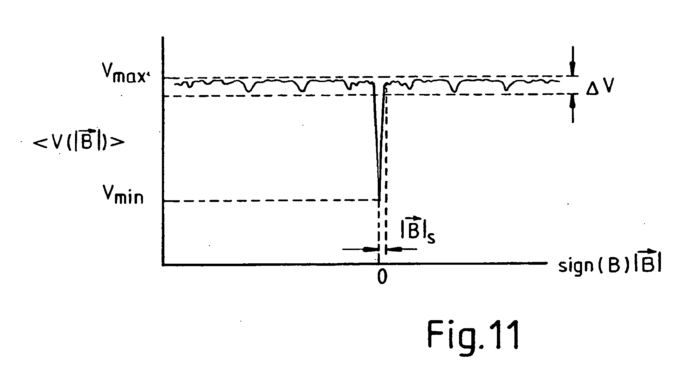

In den Fig. 9a und 9b wird der supraleitende Quanten-Interferenz-Filter konstituiert durch ein ebenes Netzwerk 101, 102 aus den Josephsonkontakten 103, 104, das Zellen 107 bis 113 bzw. 107a bis 114a besitzt, welche jeweils zwei Kontakte in Stromrichtung besitzen. Das Schaltbild des äquivalenten supraleitenden Stromkreises eines SQIF mit $N$=10 Kontakten ist in Fig. 10 dargestellt. Das Netzwerk ist dadurch gekennzeichnet, dass die einzelnen Flächen der Zellen 101 bis 109 eine unterschiedliche Größe besitzen und die Flächeninhalte $|a_j|$ der verschiedenen Netzwerkzellen in keinem rationalen Verhältnis zueinander stehen. Mit 114 sind Ersatzwiderstände bezeichnet. Das Kreuz kennzeichnet die Josephsonkontakten 101 bis 110. Durch den strichpunktierten Kasten um die Josephsonkontakte wird der supraleitend verbundene Bereich verdeutlicht. Die fett durchgezogenen Linien innerhalb dieses Kastens symbolisieren supraleitende Verbindungen. Insbesondere unter diesen Voraussetzungen entsteht der physikalische Effekt der multiplen makroskopischen Quanten-Interferenz derart, dass die quantenmechanischen Wellenfunktionen, welche den Zustand der einzelnen supraleitenden Bereiche des Netzwerks beschreiben, nur dann konstruktiv interferieren, wenn der das Netzwerk durchsetzende magnetische Fluss identisch verschwindet. Der makroskopische Gesamtzustand des Netzwerks kann dadurch ausgelesen werden, dass das Netzwerk durch einen konstanten oder einen zeitveränderlichen überkritischen Strom $I_0$ getrieben wird. Dann ergibt sich eine Spannungsantwortfunktion $\left\langle V(\vec{B};I_0) \right\rangle$, die nur ein globales absolutes Minimum bei $|\vec{B}| = 0$ besitzt und bei anwachsendem $|\vec{B}|$ monoton ansteigt, bis schließlich ein annähernd konstant bleibender Wert $V_{max}(\vec{B};I_0)$ erreicht wird, der sich bei weiter anwachsendem $|\vec{B}|$ nicht mehr wesentlich ändert, wie dies in Fig. 11 für ein Netzwerk mit $N$=30 Kontakten schematisch dargestellt ist. Für ein am Ort des Netzwerks vorhandenes magnetisches Feld $\vec{B}$ mit $0 < |\vec{B}| < |\vec{B}|_s$ ist die Spannungsantwortfunktion des supraleitenden Quanten-Interferenz-Filters daher eindeutig. Für $|\vec{B}| > |\vec{B}|_s$ ergibt sich eine nahe bei $V_{max}$ schwankende Spannungsantwort, deren Varianz mit anwachsendem $N$ schnell kleiner wird, wobei $V_{max}$ das globale absolute Maximum der Spannungsantwortfunktion ist (vgl. Fig. 11). Der Messbereich des supraleitenden Quanten-Interferenz-Filters wird bestimmt durch den Abstand zwischen dem globalen Minimum $V_{min} = \left\langle V(|\vec{B}| = 0;I_0) \right\rangle$ und $V_{max} - \Delta V$, wobei $\Delta V$ den Abstand zwischen dem kleinsten lokalen Minimum für $|\vec{B}| > |\vec{B}|_s$ und $V_{max}$ bezeichnet. Der Wert $|\vec{B}| = 0$ definiert damit die untere Grenze des Messbereichs und der Wert von $|\vec{B}|$, an dem die Spannungsantwort den Wert $V_{max} - \Delta V$ erreicht, definiert die obere Grenze $|\vec{B}|_s$ des Messbereichs (vgl. Fig. 11). Die Größe von $\Delta V$ hängt dabei von der Zahl der Zellen, welche das Netzwerk besitzt, und von der Wahl der Flächeninhalte der einzelnen Netzwerkzellen, bzw. von deren Verhältnissen zueinander ab. Dies wird in der im nächsten Absatz folgenden theoretischen Beschreibung des supraleitenden Quanten-Interferenz-Filters näher erläutert.

In den Fig. 10b bis f sind Ausführungsformen von Netzwerken skizziert, bei welchen die einzelnen Netzwerkzellen zusätzlich zu den zwei funktional notwendigen Kontakten 103 gemäß Fig. 10a einen weiteren Kontakt oder mehrere weitere Kontakte umfassen. Die Kontakte sind dabei als Kreuze gekennzeichnet. Die dick durchgezogenen Linien kennzeichnen supraleitende Verbindungen. Die dünn durchgezogenen Linien können normalleitend oder supraleitend sein. Die zusätzlichen Kontakte können dabei derart in den einzelnen Netzwerkzellen angebracht werden, dass durch sie kein oder nur ein geringer Teil des treibenden Stroms fließt (nicht direkt bestromte Kontakte 103a) und im Mittel auch keine zeitveränderliche Spannung abfällt. Durch solche Ausführungsformen können die von einem magnetischen Feld in den einzelnen Zellen induzierten Abschirmströme reduziert werden. Des Weiteren kann daher der Einfluss von Eigen- und Gegeninduktivitäten dadurch vermindert werden. Die zusätzlichen Kontakte können jedoch auch so angebracht sein, dass sie vom treibenden Strom I durchflossen werden (direkt bestromte Kontakte 103b). Auch eine Kombination von einem Kontakt 103a oder mehreren Kontakten 103a und einem Kontakt 103b oder mehreren Kontakten 103b in einzelnen oder mehreren Zellen des Netzwerks ist möglich.

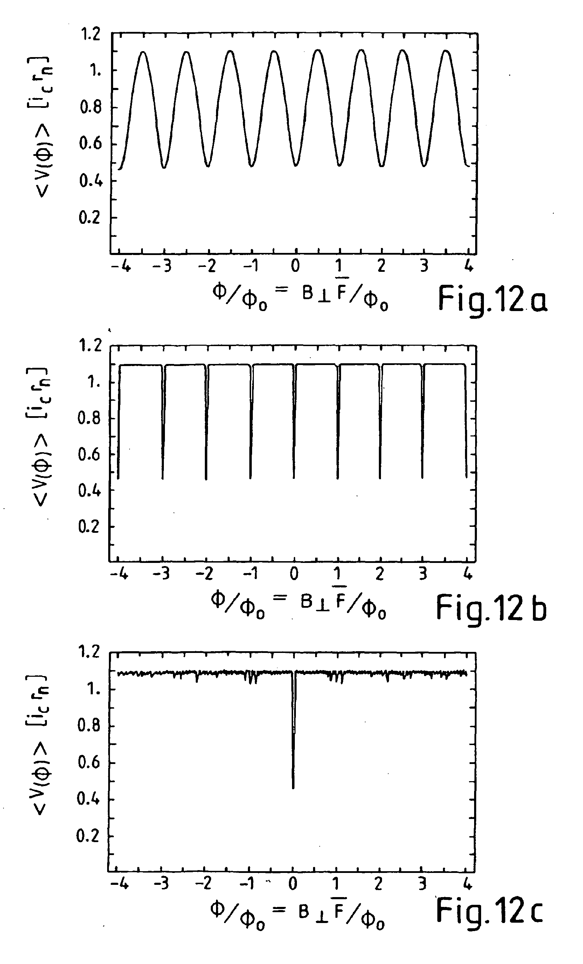

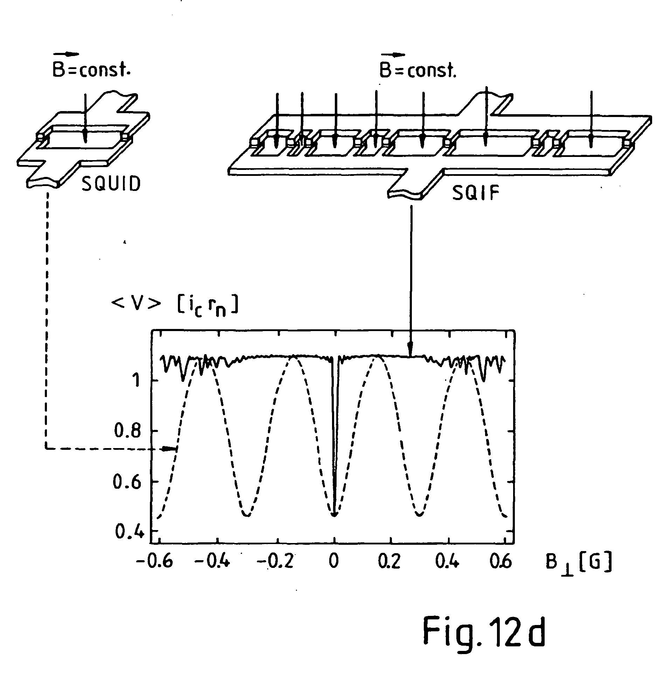

In den Fig. 12a bis 12c ist zum direkten Vergleich die Spannungsantwortfunktion eines konventionellen Einschlaufen-SQUIDs (Fig. 12a), eines konventionellen Mehrschlaufen-SQUID mit regelmäßigen Einheitszellen identischer Größe (Fig. 12b) und eines supraleitenden Quanten-Interferenz-Filters (Fig. 12c) dargestellt. Besagtes Beispiel zum Einschlaufen-SQUID besteht aus einer einzelnen supraleitenden Schlaufe bzw. Zelle mit zwei Josephsonkontakten, der Mehrschlaufen-SQUID aus einer Parallelanordnung solcher identischer Einschiaufen-SQUIDs ("Leiterarray") mit $N$=30 Kontakten, und der supraleitende Quanten-Interferenz-Filter besitzt ebenfalls $N$=30 Kontakte. Der treibende Strom $I_0$ ist für alle drei Anordnungen so gewählt, dass für $|\vec{B}|=0$ der Strom pro Kontakt den Wert 1.1 $i_c$ besitzt, so dass der Spannungshub $V_{max}$- $V_{min}$ für alle drei Vorrichtungen gleich ist. In Fig. 12d sind die Spannungsantwortfunktionen eines konventionellen SQUIDs und eines SQIFS noch einmal anhand eines konkreten Ausführungsbeispiels dargestellt. Während Einschlaufen-SQUIDs und Mehrschlaufen-SQUIDs eine periodische Spannungsantwortfunktion $\langle V \rangle$ mit der Periode $\Phi_0$ derart besitzen, dass keine absolute Messung des magnetischen Feldes möglich ist, besitzt der ebene supraleitende Quanten-Interferenz-Filter eine eindeutige Spannungsantwortfunktion. Diese Spannungsantwortfunktion des SQIFs ermöglicht dadurch die absolute quantitative Messung des magnetischen Feldes. Im gewählten Beispiel liegt der Messbereich zwischen $\Phi$=0 und $\Phi \equiv B_\perp \overline{F} \approx 0.02\,\Phi_0$ . Bei einer mittleren Netzwerkzellenfläche $\overline{F}$ im Bereich von $\mu m^2$ entspricht dies Magnetfeldstärken zwischen $B_\perp$=0 und $B_\perp$=$10^{-4}$ T und für $\overline{F}$ im Bereich von mm$^2$ Magnetfeldstärken zwischen $B_\parallel$=0 T und $B_\parallel$=$10^{-10}$ T. Die Auflösungsgrenze kann bei diesen Beispielen im Bereich von $10^{-13}$ T bis $10^{-16}$ T liegen.

Durch Verwendung einer Kompensationsschaltung, mit deren Hilfe ein magnetischer Fluss bekannter Stärke kontrolliert in den supraleitenden Quanten-Interferenz-Filter eingekoppelt werden kann, lässt sich der Messbereich der erfindungsgemäßen Vorrichtung bei gleichbleibender Empfindlichkeit beliebig variieren.

Die elektrotechnische theoretische Beschreibung des supraleitenden Quanten-Interferenz-Filters kann mit Hilfe des sogenannten RCSJ -Modells (RCSJ = resistively and capacitively shunted junction) für die einzelnen Josephsonkontakte unter Berücksichtigung der Netzwerktheorie für supraleitende Schaltungen erfolgen. Im RCSJ-Modell wird der einzelne Josephsonkontakt durch eine nichtlineare Induktivität beschrieben, der ein ohmscher shunt-Widerstand $r_n$ und eine geometrische, die Tunnelbarriere charakterisierende shunt-Kapazität $c_n$ parallelgeschaltet sind. Die Beschreibung des makroskopischen Zustands der Josephsonkontakte erfolgt durch die eichinvariante Differenz der makroskopischen quantenmechanischen Phasen an den beiden gegenüberliegenden supraleitenden Elektroden des jeweiligen Kontakts. Diese Phasendifferenz wird mit $\phi_j$ bezeichnet, wobei $j$=1...$N$ die einzelnen Kontakte des Netzwerks indiziert. Die der Netzwerkdynamik zugrundeliegenden Relationen sind dann durch

$$I_j = i_c \sin(\phi_j) + \frac{v_j(t)}{r_n} + c_n\,\partial_t v_j(t), \qquad (1)$$

$$v_j(t) = \frac{\hbar}{2e}\partial_t\phi_j, \qquad (2)$$

$$\phi_{j+1} - \phi_j = 2\pi\,\frac{\Phi_j}{\Phi_0} \qquad (3)$$

gegeben, wobei $I_j$ den durch den Kontakt mit Index $j$ fließenden Strom mit $\sum_{j=1}^{N} I_j = I_0$ und $\Phi_j$ den die Netzwerkzelle mit Index $j$ durchsetzenden magnetischen Fluss bezeichnet. Gleichung 1 beschreibt die nichtlineare Relation zwischen dem Strom $I_j$ und der über dem Kontakt abfallenden Spannung $v_j(t)$ im RCSJ Modell. Gleichung 2 entspricht der zweiten Josephson-Relation, nach der die über dem Kontakt abfallende Spannung $v_j(t)$ direkt proportional der zeitlichen Ableitung $\partial_t\phi_j$ der Phasendifferenz $\phi_j$ ist. Gleichung 3 ist Ausdruck der Quantisierung des magnetischen Flusses durch eine geschlossene supraleitende Schlaufe.

Der Einfachheit halber wird bei der theoretischen Beschreibung angenommen, dass die Netzwerkkontakte identisch sind, d.h. dass sowohl die kritischen Ströme $i_c$ als auch die parallelgeschalteten shunt-Widerstände $r_n$ und shunt-Kapazitäten $c_n$ nicht statistisch oder systematisch streuen. Das Auftreten von typischen fertigungsbedingten Parameterstreuungen beeinträchtigt die Funktionsfähigkeit des supraleitenden Quanten-Interferenz-Filters jedoch nicht. Die theoretische Beschreibung im Rahmen des RCSJ-Modells beschränkt sich zudem auf sogenannte Punktkontakte, d.h. auf Kontakte, die so klein sind, dass die Phasendifferenzen über die Ausdehnung der Kontaktbarriere nicht variieren. Dies ist eine auch bei der theoretischen Beschreibung konventioneller SQUIDs übliche Annahme. Bei supraleitenden Quanten-Interferenz-Filtern ist diese Annahme in besonderer Weise gerechtfertigt, da im Gegensatz zu konventionellen SQUIDs die auftretenden Interferenzmuster mit wachsender Zahl der Netzwerkzellen von der Netzwerkdynamik dominiert werden und daher nur äußerst schwach von der speziellen Geometrie der einzelnen Kontakte abhängen.

Die aus der Stromerhaltung und den Gleichungen 1 bis 3 folgenden Netzwerkgleichungen verknüpfen das am Ort des Netzwerks wirkende Magnetfeld $\vec{B}$ und den treibenden Strom $I_0$ mit der über der Schaltung abfallenden Spannung $V(t)$. Für statische oder im Vergleich zur Netzwerkfrequenz langsam variierende Magnetfelder $\vec{B}$ kann die Netzwerkgleichung für den SQIF dieses Ausführungsbeispiels und allgemein für SQIFs, die aus parallel geschalteten Netzwerkzellen bestehen, als nichtlineare Differentialgleichung der Form

$$\frac{\hbar}{2e}\frac{c_n}{i_c}\partial_t^2\phi_1 + \frac{\hbar}{2e\,i_c\,r_n}\partial_t\phi_1 + \left|S_N(\vec{B})\right|\sin(\phi_1 + \delta_N) = \frac{I_0}{N\,i_c} \qquad (4)$$

$$v_1(t) = \frac{\hbar}{2e}\partial_t\phi_1 \qquad (5)$$

geschrieben werden, wobei sich das Magnetfeld $\vec{B} = \vec{B}_{ext} + \vec{B}_c$ aus dem zu messenden, primärem äußeren Feld $\vec{B}_{ext}$ und eventuell einem kontrolliert erzeugten, sekundären magnetischen Kompensationsfeld $\vec{B}_c$ zusammensetzt. Der in Gleichung 4 auftretende komplexe $(i = \sqrt{-1})$ Strukturfaktor $S_N(\vec{B}) = \left|S_N(\vec{B})\right|\exp\left[i\,\delta_N(\vec{B})\right]$ beschreibt die geometrischen und dynamischen Eigenschaften des aus $N$-1 Zellen zusammengesetzten supraleitenden Quanten-Interferenz-Filters. Er bestimmt die räumlichen und zeitlichen Interferenzeigenschaften des Netzwerks in Abhängigkeit von der Stärke des zu messenden Magnetfelds. Die Phasenverschiebung $\delta_N$ hängt ebenfalls von der speziellen Geometrie der Anordnung ab, hat jedoch keinen Einfluss auf die zeitlich gemittelte Spannungsantwortfunktion $\left\langle V(\vec{B};I_0) \right\rangle$.

Der komplexe Strukturfaktor $S_N(\vec{B})$ ist zu

$$S_N(B) = \frac{1}{N}\sum_{n=0}^{N-1}\exp\left(\frac{2\pi i}{\Phi_0}\sum_{m=0}^{n}\left\langle\vec{B},\vec{a}_m\right\rangle\right) \qquad (6)$$

definiert, wobei die Vektoren $\vec{a}_m$ die orientierten Flächenelemente ($\frac{\vec{a}_m}{|\vec{a}_m|}$ = Flächennormale, $|\vec{a}_m|$ = Flächeninhalt der m-ten Schlaufe) der einzelnen Netzwerkschlaufen bezeichnen und $\vec{a}_0 = 0$ gilt. Für den die einzelnen Netzwerkschlaufen durchsetzenden magnetischen Fluss gilt damit $\Phi_m = \left\langle\vec{B},\vec{a}_m\right\rangle$, wobei für zwei beliebige Vektoren $\vec{a},\vec{b}$ das Skalarprodukt durch $\left\langle\vec{a},\vec{b}\right\rangle = |\vec{a}||\vec{b}|\cos\angle(\vec{a},\vec{b})$ definiert ist. Variiert das Magnetfeld $\vec{B}$ über die Ausdehnung der Schlaufe, dann tritt an die Stelle dieses Skalarprodukts die entsprechende Integraldarstellung. Die Periodizität des Netzwerks wird durch die akkumulierten magnetischen Flüsse

$$\alpha_n = \sum_{m=0}^{n} \left\langle \vec{B}, \vec{a}_m \right\rangle \qquad\qquad (7)$$

mit $n$ = 0...$N$-1 bestimmt.

Für konventionelle Einschlaufen-SQUIDs, bei denen nur eine orientierte Fläche $\vec{a}_1$ existiert, nimmt $S_N$ mit $N$=2 den Wert $S_2 = \frac{1}{2}\left(1 + \exp\left[\frac{2\pi i}{\Phi_0}\Phi\right]\right)$ und $\left|S_2\right| = \cos\left(\frac{\pi\,\Phi}{\Phi_0}\right)$ an. Für ebene periodische Mehrschlaufen-SQUIDs mit identischen Schlaufenflächen $\vec{a}_1 = \vec{a}_2 = \vec{a}_3 = ... = \vec{a}_{N-1}$ ist $\alpha_n = n\Phi$ mit $\Phi = B_\perp \left|\vec{a}_1\right|$, so dass $S_N = \frac{1}{N}\sum_{n=0}^{N-1}\exp\left[\frac{2\pi i}{\Phi_0}n\,\Phi\right]$ eine geometrische Reihe ist, mit dem Ergebnis $\left|S_N\right| = \frac{\sin(N\,\pi\,\Phi/\Phi_0)}{N\sin(\pi\,\Phi/\Phi_0)}$. Die Strukturfaktoren für solche dem derzeitigen Stand der Technik entsprechenden konventionellen SQUIDs besitzen somit unabhängig von der Zahl der Kontakte periodische Strukturfaktoren. Diese periodischen Strukturfaktoren sind die Ursache für die ebenfalls streng $\Phi_0$-periodischen Spannungsantwortfunktionen $\left\langle V(\vec{B};I_0) \right\rangle$ solcher Vorrichtungen, und damit die Ursache dafür, dass mit solchen dem Stand der Technik entsprechenden Vorrichtungen eine absolute Messung des magnetischen Feldes nicht möglich ist. Supraleitende Quanten-Interferenz-Filter besitzen demgegenüber keine periodischen Strukturfaktoren, da $S_N(\vec{B})$ nach Gleichung 6 für inkommensurable akkumulierte magnetische Flüsse $\alpha_n$ keine Periodizität aufweisen kann. Supraleitende Quanten-Interferenz-Filter besitzen damit auch keine periodischen Spannungsantwortfunktionen $\left\langle V(\vec{B};I_0) \right\rangle$ und ermöglichen dadurch die absolute Messung magnetischer Felder.

Nach Gleichung 3 gilt für statische oder im Vergleich zur Netzwerkfrequenz langsam variierende äußere Felder $v_j(t) = v_1(t)$ für alle j = 1 ...N, d.h. $v_1(t)$ definiert die über den supraleitenden Quanten-Interferenz-Filter abfallende Wechselspannung. Die Netzwerkfrequenz $\nu$ hängt über die Einstein-Relation $h\nu = 2e\left\langle V(\vec{B};I_0)\right\rangle$ mit dem zeitlichen Mittelwert dieser Wechselspannung, der Spannungsantwortfunktion $\left\langle V(\vec{B};I_0)\right\rangle = \frac{1}{T}\int_0^T v_1(t)\,dt$ zusammen, wobei $T = \frac{1}{\nu}$ gilt. Für typische Nb|AlO$_x$|Nb-Josephsonkontakte liegt die Netzwerkfrequenz $\nu$ bei etwa 100 GHz, so dass die Frequenz $\nu_{ext}$ des äußeren Feldes in einem Bereich zwischen $\nu_{ext}$=0 bis etwa 20 GHz liegen kann. Als einfach zugängliche Messgröße kann wie bei konventionellen SQUIDs die im zeitlichen Mittel über das Netzwerk abfallende Gleichspannung $\left\langle V(\vec{B};I_0)\right\rangle$ dienen. Der Einfluss von Induktivitäten und durch den Treiberstrom verursachten Eigenfelder wird in Gleichung 4 und 5 der besseren Verständlichkeit halber vernachlässigt. Tatsächlich können Induktivitäten und Eigenfelder bei geeigneter Auslegung des supraleitenden Quanten-Interferenz-Filters so minimiert werden, dass deren Funktionsfähigkeit durch diese Einflüsse nicht beeinträchtigt wird. Entsprechende Vorrichtungen werden in den weiteren Ausführungsbeispielen vorgestellt.

Die Vernachlässigung der shunt-Kapazitäten $c_n$, die für typische Josephsonkontakte in sehr guter Näherung gerechtfertigt ist, ermöglicht eine analytische Lösung für die Spannungsantwortfunktion:

$$\left\langle V(B;I_0)\right\rangle = i_c\,r_n\sqrt{\left(\frac{I_0}{N\,i_c}\right)^2 - \left|S_N(B)\right|^2} \qquad\qquad (8)$$

Für alle dem derzeitigen Stand der Technik entsprechenden SQUIDs ist diese Spannungsantwortfunktion periodisch mit Periode $\Phi_0$, wie dies in Fig. 12a skizziert ist. Für SQIFs hingegen ist die Spannungsantwortfunktion nicht periodisch. Dies ist in Fig. 12c dargestellt. Die Spannungsantwortfunktion des supraleitenden Quanten-Interferenz-Filters besitzt wie die Spannungsantwortfunktion konventioneller SQUIDs ein Minimum für $\Phi$=0. Im Gegensatz zu konventionellen SQUIDs wiederholt sich dieses Minimum bei anwachsendem äußerem Feld jedoch nicht. Damit ist die Spannungsantwort für Φ=0 eindeutig ausgezeichnet und ermöglicht je nach Auslegung direkt oder mit Hilfe einer geeigneten Kompensationsschaltung für das magnetische Feld die absolute quantitative Messung des äußeren magnetischen Feldes. Da der Betrag des Strukturfaktors $S_N$ in Gl. 8 quadratisch eingeht, schwankt die Spannungsantwortfunktion für die SQIFs auf dem oberen Teil des Graphen nur sehr leicht um den Wert $V_{max}$ und es ergibt sich eine ausgeprägt steile Flanke zwischen $V_{min}$ und $V_{max}$ (vgl. Fig. 12c).

Der Strukturfaktor $S_N(\vec{B})$ des supraleitenden Quanten-Interferenz-Filters kann derart optimiert werden, dass die Spannungsantwortfunktion $\langle V(\vec{B}; I_0) \rangle$ einen maximalen Messbereich $0 < |\vec{B}| < |\vec{B}|_s$ besitzt. Dies ist dann der Fall, wenn der Abstand $\Delta V$ zwischen dem kleinsten lokalen Minimum von $V$ und dem maximalen Spannungswert $V_{max}$ für gegebene Gesamtfläche $\sum_{m=1}^{N-1} |\vec{a}_m|$ (vgl. auch Fig. 11) und gegebene Zahl der Netzwerkkontakte $N$ im Operationsbereich minimal wird. Der maximale Operationsbereich eines supraleitenden Netzwerkes ist dabei durch die maximal erreichbare Kompensationsfeldstärke bestimmt.

Für ebene Netzwerke kann der Fall eintreten, dass eine durch den Fertigungsprozess verursachte minimal mögliche Längenvariation $l_0$ der Leiterbahnen auftritt. Die Flächeninhalte $|\vec{a}_m|$ der Netzwerkschlaufen können dann durch $|\vec{a}_m| = q_m l_0^2$ definiert werden, wobei die Zahlen $q_m$ positive ganze Zahlen sind. Im ungünstigsten Fall dürfen sich damit zwei Flächenelemente fertigungsbedingt nur um den Betrag von $l_0^2$ unterscheiden. Dies führt dazu, dass der Strukturfaktor $S_N(\vec{B})$ und damit die Spannungsantwortfunktion $\langle V(\vec{B}; I_0) \rangle$ des supraleitenden Quanten-Interferenz-Filters rein theoretisch betrachtet periodisch variieren könnte. Die möglicherweise auftretende Periode ist allerdings in Bezug auf $\Phi_0$ sehr groß und entspricht $\frac{\Phi_0}{GGT} A_{tot}$, wenn GGT der größte gemeinsame Teiler der Beträge $|\vec{a}_m|$ der orientierten Flächenelemente eines planaren Netzwerks ist und $A_{tot}$ die Gesamtfläche des SQIF, $A_{tot} = \sum_{m=1}^{N-1} |\vec{a}_m|$ bezeichnet. Ein typischer, dem Stand der Technik entsprechender Wert für $l_0$ beträgt etwa hundert $nm$ (Niob-Prozess). Die minimale Flächendifferenz $l_0^2$ liegt damit in der Größenordnung von $10^{-2} \, \mu \, m^2$ bei einer angenommenen Netzwerkzellenfläche des supraleitender Quanten-Interferenz-Filters von $10^{-2} mm^2$. Sind die Zahlen $q_m$ nun selbst teilerfremd, etwa dadurch, dass sie zu (verschiedenen) Primzahlen gewählt werden, dann ist die Periode der Spannungsantwortfunktion zu $\frac{\Phi_0}{l_0^2} A_{tot}$ gegeben. Diese Periode liegt für typische Gesamtflächen $A_{tot}$ von mehreren 1000 $\mu$ m$^2$ weit außerhalb des praktisch relevanten Mess- oder Operationsbereichs. Für einen in einer bestimmten Anwendung gegebenen Operationsbereich existiert damit immer ein supraleitender Quanten-Interferenz-Filter mit optimaler Fläche, Kontaktanzahl und zugehörigem Strukturfaktor.

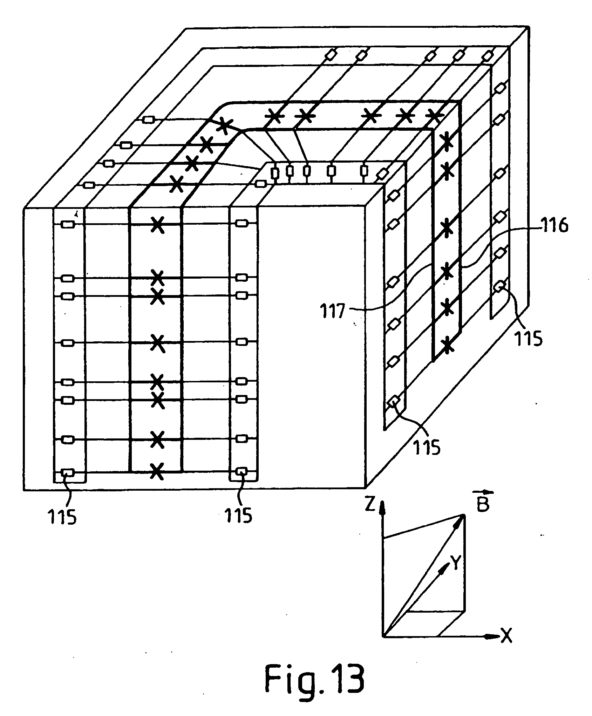

Ein weiteres Ausführungsbeispiel der Erfindung ist in Fig. 13 dargestellt. Die Netzwerkzellen zerfallen hier in drei Gruppen derart, dass aus den orientierten Flächenelementen $\vec{a}_m$ eine vollständige vektorielle Basis des dreidimensionalen Raumes gebildet werden kann. Diese Ausführung der Erfindung, die im Folgenden als Vektor-SQIF bezeichnet wird, hat den Vorteil, dass durch entsprechend ausgelegte Kompensationsfelder, die zum Beispiel jeweils ein kontrollierbares sekundäres Feld parallel zu jedem der aus den $a_m$ gebildeten Basisvektoren erzeugen, sowohl die Stärke als auch die Richtung des zu messenden primären magnetischen Feldes eindeutig und mit sehr hoher Genauigkeit bestimmt werden kann. Dies ermöglicht die eindeutige quantitative Rekonstruktion des primären Magnetfeldvektors $\vec{B}_{ext}$ nach Betrag, Richtung und Phase, und erlaubt eine Vielzahl neuartiger Anwendungen. Schon mit zwei solcher Anordnungen ist es z.B. möglich, die Quellen eines magnetischen Feldes exakt zu lokalisieren und ihre Stärke zu bestimmen. Hierzu kann das drahtlose Auslesen von Detektorfeldern gehören, wenn die einzelnen Detektorsignale aus temporären elektrischen Strömen bestehen. Auch das Auslesen oder die Verarbeitung von elektronischen oder magnetischen Datenspeichern ist durch solche Anordnungen berührungslos und praktisch ohne Leistungsaufnahme oder -abgabe durch den SQIF bei einer sehr hohen zeitlichen Auflösung und damit einer extrem schnellen Verarbeitungsgeschwindigkeit im GHz bis THz Bereich möglich. Weitere Beispiele für die Anwendung solcher Vektor-SQIFs sind die räumlich und zeitlich hochaufgelöste Messung von Stoffwechselvorgängen, etwa im menschlichen Gehirn, von Signalen der Kernspin-Resonanz oder der Magnetfeldverteilung in der oberen Erdkruste, wie etwa in der Geoexploration. In Fig. 13 sind durch die Kreuze die Josephsonkontakte symbolisiert, mit dem Bezugszeichen 115 sind bus-bar-Widerstände bezeichnet. Die dicken durchgezogenen Linien stellen supraleitende Verbindungen dar. Die beiden dicken durchgezogenen Linien 116, 117 begrenzen zudem den supraleitend verbundenen Teil des Netzwerks.

In einem nicht dargestellten Ausführungsbeispiel ist der Vektor-SQIF aus drei unabhängig voneinander operierenden einzelnen ebenen SQIFs, deren Flächennormalen eine vektorielle Basis des dreidimensionalen Raumes bilden, aufgebaut. Diese Vorrichtung hat den Vorteil, dass die einzelnen ebenen SQIFs mit den dem derzeitigen Stand der Technik entsprechenden Standardmethoden der Dünnschichttechnologie problemlos gefertigt werden können. Die quantitative Messung kann hier entweder durch simultane Kompensation der drei Komponenten des äußeren Magnetfelds wie im Ausführungsbeispiel des letzten Abschnitts oder durch direkte Messung der an jedem einzelnen SQIF abfallenden Spannung erfolgen. Letztere Messmethode ist für bestimmte Anwendungen ein weiterer Vorteil solcher Anordnungen, da dann keine Kompensationsvorrichtungen notwendig sind.

In zwei weiteren nicht dargestellten Ausführungsbeispielen ist der Vektor-SQIF entsprechend dem letzten oder vorletzten Abschnitt so aufgebaut, dass die Flächennormalen der einzelnen SQIFs oder die orientierten Flächenelemente

$\vec{a}_m$    derart angeordnet sind, dass aus ihnen eine vollständige vektorielle Basis eines zweidimensionalen Unterraumes des dreidimensionalen Raumes gebildet werden kann. Diese Ausführung kann dann von Vorteil sein, wenn das magnetische Feld nur in einer Ebene gemessen werden soll, z.B. wenn es sich um ebene Detektorfelder oder Speicher handelt.

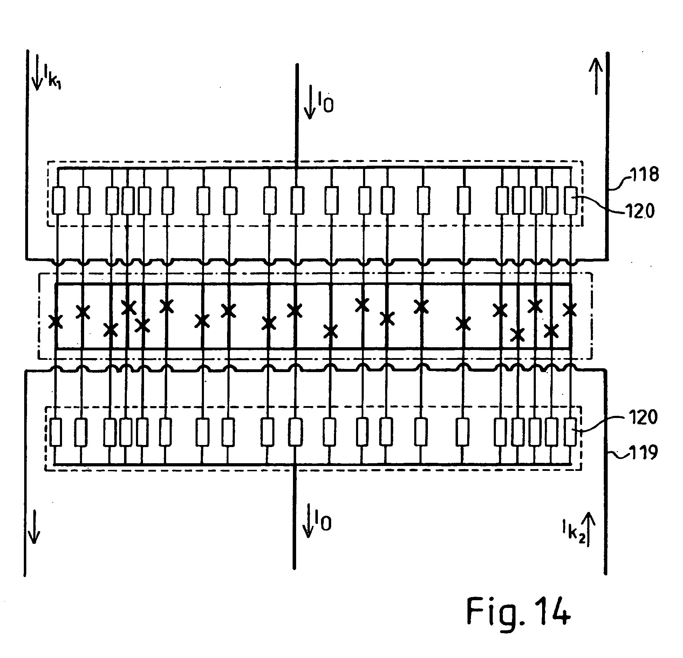

In Fig. 14 ist ein Ausführungsbeispiel eines ebenen SQIFs dargestellt, bei dem das magnetische Kompensationsfeld durch zwei Steuerleitungen 118, 119, welche parallel zum Netzwerk und damit senkrecht zur Richtung des treibenden Stromes liegen, erzeugt wird. Fließt in einer solchen erfindungsgemäßen Anordnung ein Strom $I_{k1}$, $I_{k2}$ durch eine oder beide Steuerleitungen 118, 119, so wird in die Zellen des SQIF ein durch diesen Strom sehr genau kontrollierbarer magnetischer Fluss bekannter Stärke eingekoppelt. Dieser Fluss kann den durch ein äußeres magnetisches Feld verursachten Fluss derart kompensieren, dass die über den SQIF abfallende Spannung minimal wird. Dieser sogenannte Arbeitspunkt liegt dann immer im absoluten Minimum der Eichkurve $\left\langle V(\vec{B};I_0)\right\rangle$ des SQIF. Über den Wert des Kompensationsstroms kann, da der Abstand zwischen Steuerleitung und Netzwerk bekannt ist, die Stärke des äußeren Magnetfelds direkt bestimmt werden. Auch die Wahl eines anderen Arbeitspunkts innerhalb des Messbereichs des SQIF ist möglich. Diese Ausführung hat den Vorteil, dass der Operationsbereich des SQIF, d.h. der Bereich der Magnetfeldstärken, die mit der Vorrichtung gemessen werden können, prinzipiell nur durch Feldstärken, die die Phasenkohärenz zwischen den durch Tunnelbarrieren getrennten supraleitfähigen Bereichen zerstören, nach oben hin begrenzt ist. Ein weiterer Vorteil ist, dass in dieser Ausführung SQIFs auch dann noch voll funktionsfähig betrieben werden können, wenn der eigentliche Messbereich, d.h. der Bereich in dem die Spannungsantwortfunktion ein-eindeutig ist, sehr klein wird. Dies kann dann auftreten, wenn durch fertigungsbedingte Toleranzen Nebenminima der Spannungsantwortfunktion auftreten, deren Spannungswerte sich nicht sehr stark vom Spannungswert des absoluten Minimums unterscheiden. Solange der Messbereich jedoch größer als die Auflösungsgrenze des SQIF, die typischerweise bei einigen nV liegt, bleibt die Vorrichtung erfindungsgemäß in einer Ausführung mit Kompensationsschaltung voll funktionsfähig. Vorteilhaft an einer Ausführung mit Steuerleitungen ist auch, dass die Kompensationsschaltung on-chip angebracht ist und keine zusätzlichen Fertigungsschritte erfordert. Entsprechend dem derzeitigen Stand der Technik können die Steuerleitungen bei Dünnschichtaufbauten in den über oder den unter den Netzwerk-Zuführungsleitungen liegenden Schichten angebracht werden. Auch das Anbringen von mehreren Steuerleitungen kann von Vorteil sein, etwa wenn zu Präzisionsmessungen einem statischen Kompensationsfeld ein zeitlich variierendes Kompensationsfeld überlagert werden soll.

Für Operationsmodi, bei denen zeitlich variierende Kompensationsfelder verwendet werden, sollten SQIFs ihre maximale Empfindlichkeit erreichen. In solchen Modi ist darüber hinaus nicht nur die simultane Bestimmung der Stärke und der Richtung des zu messenden Feldes, sondern auch seiner Phasenlage möglich. Dies erlaubt die vollständige Rekonstruktion des gemessenen zeitveränderlichen Signals und damit die Erstellung einer identischen Kopie dieses Signals. Der Vorteil der Vorrichtungen liegt darin, dass solche Kopien ohne jeden Informationsverlust verstärkt und weitergeleitet werden können.

In Fig. 14 symbolisieren wiederum die Kreuze die Josephsonkontakte. Mit dem Bezugszeichen 120 sind symbolisch dargestellte bus-bar-Widerstände bezeichnet. Die strichpunktierte Linie beschreibt die Begrenzung des notwendigerweise supraleitenden Teils des Netzwerks.

In einer nicht dargestellten Ausführung für Präzisionsmessungen ist die Kompensationsschaltung außerhalb des SQIF angebracht und besteht aus einem Spulenpaar, welches derart orientiert ist, dass der SQIF in einer Ebene senkrecht zur Achse des Spulenpaars zwischen den beiden Spulen liegt. Solche Kompensationsschaltungen können den Vorteil haben, dass das magnetische Kompensationsfeld am Ort des SQIF eine sehr hohe Homogenität aufweist und dadurch äußerst präzise Messungen ermöglicht. Auch Ausführungen, bei denen lokal, d.h. durch Steuerleitungen, und durch außerhalb des SQIF angebrachte Kompensationsschaltungen, kompensiert wird, können von Vorteil sein, um den Einfluss von Störungen, wie etwa Rauschen und Fluktuationen, zu minimieren.

SQIF, welche über Kompensationsschaltungen, etwa in Form von Steuerleitungen verfügen, können auch als Logikbauelemente (Aktoren) für ultraschnelle Hochleistungsrechner verwendet werden. SQIFs mit zwei lokalen Steuerleitungen können ODER-Logikbausteine bereitstellen, die nur dann schalten, wenn durch beide Steuerleitungen ein exakt gleicher paralleler Strom fließt. Die Schaltzeiten solcher Aktoren liegen dabei im Bereich der Netzwerkfrequenz, d.h. im GHz bis THz Bereich. Ein Vorteil solcher Logikbausteine liegt dabei auch darin, dass sie gleichzeitig als Verstärker wirken, da sehr kleine Steuerströme bereits zur maximalen Spannungsantwort führen, die für heutzutage typische Josephsonkontakte mehrere hundert $\mu$ *V* bis *mV* beträgt.

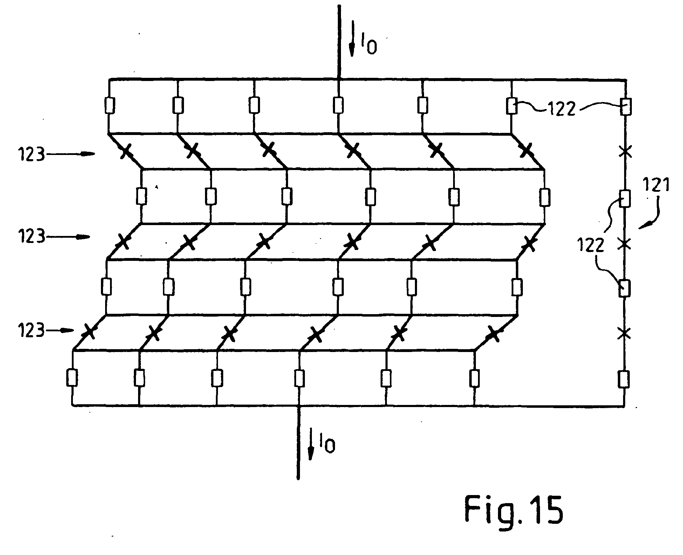

Durch eine Serienschaltung von SQIFs, wie dies in Fig. 15 dargestellt ist, die durch eine aktive Steuerleitung 121, welche ihrerseits wiederum Josephsonkontakte enthält, miteinander gekoppelt sind, kann die Empfindlichkeit bzw. der Verstärkungsfaktor der erfindungsgemäßen Anordnungen vervielfacht werden. Die Kreuze symbolisieren Josephsonkontakte. Mit dem Bezugszeichen 122 sind symbolisch dargestellte bus-bar-Widerstände bezeichnet. Die dick ausgezogenen Linien innerhalb des Netzwerks repräsentieren supraleitende Verbindungen und symbolisieren den supraleitenden Bereich 123, der auch die Josephsonkontakte enthält.

Die aktive Steuerleitung 121 bewirkt hierbei eine Synchronisation des eindimensionalen SQIF-arrays auch bei stark abweichenden Strukturfaktoren der verschiedenen SQIF-Abschnitte und Parameterinhomogenitäten. Sind die Fertigungstoleranzen klein, kann unter Umständen auf die aktive Steuerleitung auch verzichtet werden. Der Vorteil solcher SQIF-arrays, die auch zweidimensional ausgelegt sein können, liegt darin, dass die Auflösungsgrenze der Vorrichtung mit der Zahl der SQIF-Abschnitte 123 abnimmt und der Verstärkungsfaktor mit der Zahl der SQIF-Abschnitte anwächst. Im Bereich der Magnetfeldmessung sollten sich mit solchen Anordnungen bei optimaler Wahl des Operationsmodus zum Beispiel Auflösungsgrenzen erreichen lassen, die viele Größenordnungen niedriger sind als die bei konventionellen SQUID-Systemen. Auch SQIF-arrays lassen sich mit den dem Stand der Technik entsprechenden Fertigungsverfahren problemlos herstellen.

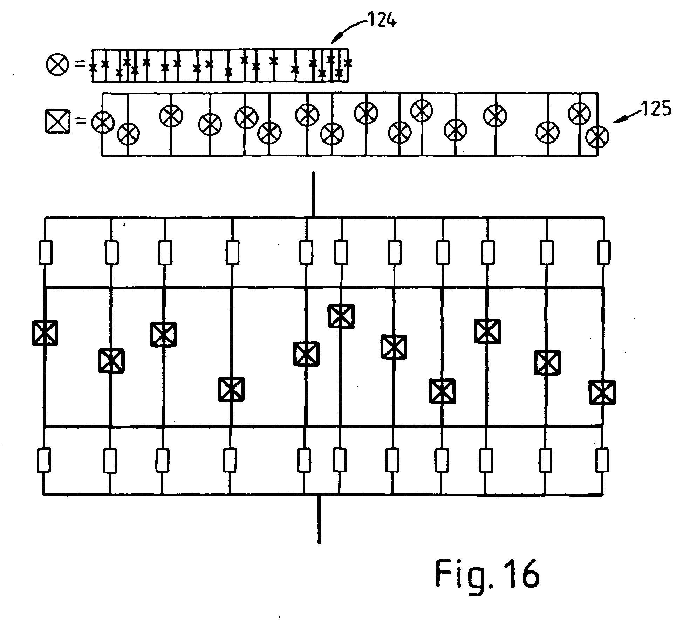

Ein Ausführungsbeispiel bei dem mehrere SQIF-Abschnitte 124 in einem hierarchisch gegliederten SQIF-array verschaltet sind, ist in Fig. 16 gezeigt. Die Basiselemente eines solchen hierarchischen SQIF-arrays sind hier identische Basis-SQIFs 124 mit identischem Strukturfaktor. Diese Basis-SQIFs sind auf einer zweiten Hierarchieebene wiederum in Form eines SQIFs 125 angeordnet, welcher erneut als Basis-SQIF 125 für eine dritte Hierarchieebene dient. Auch Anordnungen mit mehr als drei Hierarchieebenen *(k*=1,2,3,...) sind möglich. Der Vorteil solcher Anordnungen liegt darin, dass je nach den Verhältnissen der orientierten Flächenelemente des Basis-SQIF und dem oder der SQIFs höherer Hierarchieebenen, bedingt durch die im Allgemeinen verschiedenen Strukturfaktoren auf den verschiedenen Ebenen, die Interferenzmuster, die auf den verschiedenen Ebenen erzeugt werden, wiederum zu einem Gesamtmuster interferieren, was eine außerordentlich hohe Auflösung ermöglicht. Da die orientierten Flächenelemente $a_m$ in den verschie-denen Hierarchieebenen unterschiedlich ausgerichtet werden können, ist das resultierende Interferenzmuster zudem extrem sensitiv bezüglich der Richtung des äußeren Feldes. Nach dem derzeitigen Stand der Fertigungstechnik können solche mehrdimensional ausgelegten SQIF-Systeme nicht on-chip realisiert werden. Es ist jedoch möglich, die einzelnen ebenen Bestandteile eines mehrdimensionalen SQIF-Systems mit herkömmlichen Methoden der Dünnschichttechnologie herzustellen und diese dann mit supraleitenden twisted-pair-Kabeln so zu verbinden, dass ein Gesamtsystem der beschriebenen Art entsteht. Solche supraleitenden twisted-pair-Kabel haben dabei den Vorteil, dass in sie kein effektiver Fluss eindringt. Die Verbindung verschiedener Teile eines SQIF-Systems mit solchen supraleitenden twisted-pair-Kabeln beeinflusst die Funktionsfähigkeit des Gesamt-SQIFs daher nicht, da in Gl. 6 das Kabel lediglich als orientiertes Flächenelement mit verschwindend kleiner Fläche eingeht.

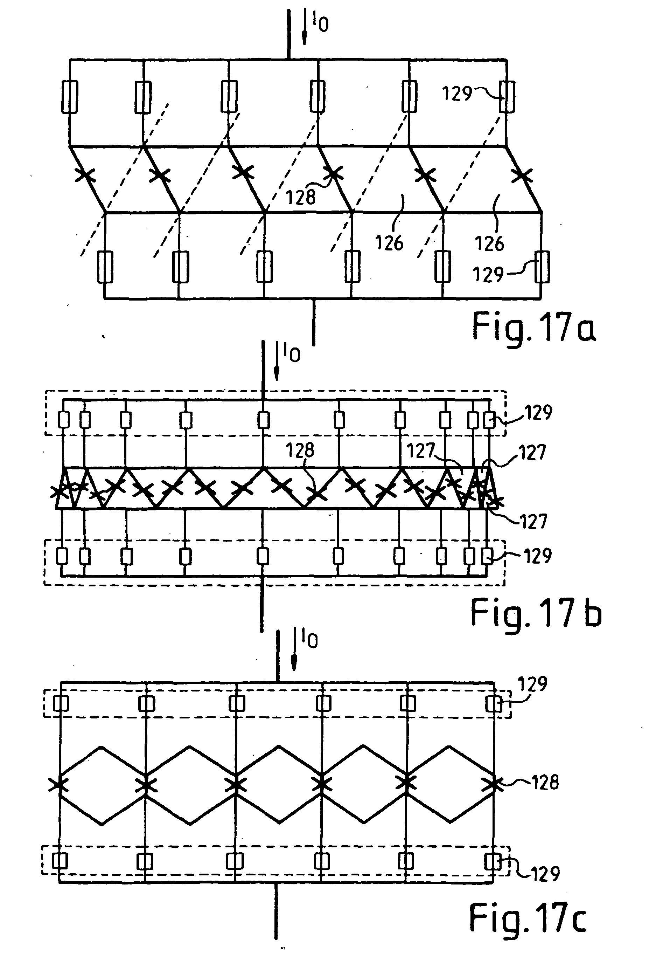

Ein Ausführungsbeispiel eines SQIF, das zeigt, wie die zwischen den verschiedenen Netzwerkzellen wirksamen induktiven Kopplungen minimiert werden können, ist in Fig. 17a dargestellt. Solche induktiven Kopplungen können die Empfindlichkeit der Vorrichtung vermindern, wenn das Netzwerk aus sehr vielen Zellen besteht. Da durch jeden Kontakt ein überkritischer Strom fließt, erzeugt die resultierende Stromverteilung in diesem Fall ein Eigenfeld, das unter Umständen nicht vernachlässigt werden kann. Durch erfindungsgemäße Ausführungen, wie sie etwa in Fig. 17b dargestellt sind, lässt sich der Einfluss der Eigenfelder stark reduzieren. In Fig. 17a und 17b sind die Leiterbahnen der Netzwerkzellen 126, 127 so ausgeführt, dass der durch einen Netzwerkkontakt 128 fließende Strom in der jeweils übernächsten Netzwerkzelle nur einen vernachlässigbaren Fluss induziert, da das magnetische Feld eines stromdurchflossenen kurzen Leiterstücks im Wesentlichen auf einen Bereich senkrecht zum Leiterstück beschränkt ist. Da für $\Phi$=0 jeder Kontakt von einem Strom gleicher Stärke durchflossen wird, verschwinden für diesen Fall alle Induktivitäten und das globale Minimum der Spannungsantwortfunktion entspricht dem nach Gl. 8. Um die Eigenfelder der stromzuführenden und abführenden Leitungen zu minimieren, wird der Treiberstrom $I_0$ durch dem Stand der Technik entsprechende bus-bar-Widerstände 129, deren Entfernung zum Netzwerk groß genug gewählt werden kann, zu- und wieder abgeführt. Eine alternative, die gegenseitigen induktiven Einflüsse ebenfalls minimierende Ausführung eines SQIF ist in Fig. 17c dargestellt.

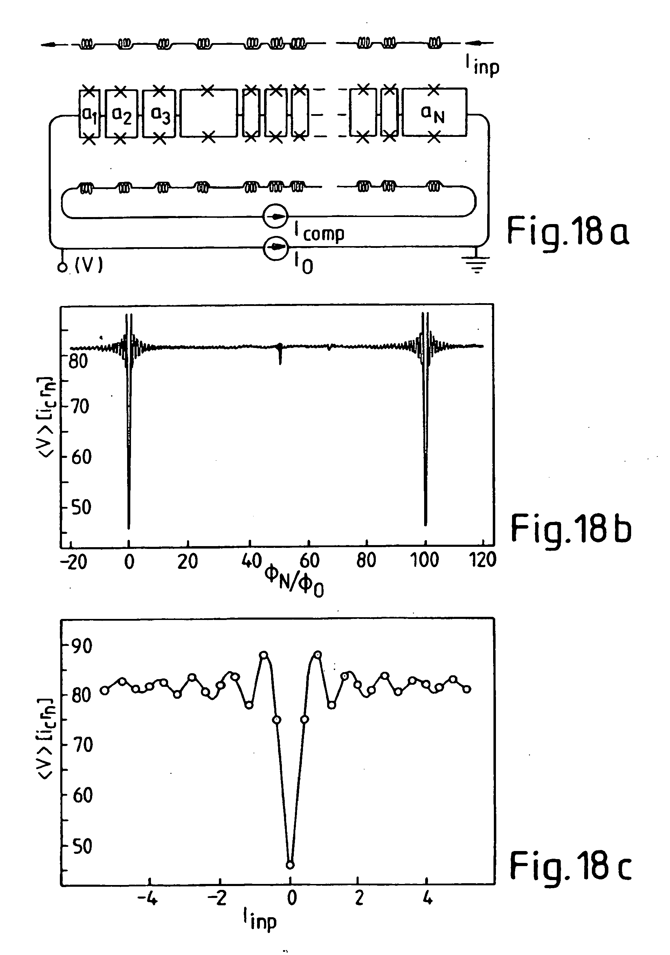

Ein Ausführungsbeispiel, bei dem die verschiedenen Netzwerkzellen in Serie geschaltet sind, ist in Fig. 18a dargestellt. Die orientierten Flächenelemente $\vec{a}_m$ sind auch hier so gewählt, dass die Spannungsantwortfunktion des Netzwerks nicht periodisch ist oder nur eine im Vergleich zu $\Phi_0$ sehr große Periode besitzt. Im Fall einer nichtperiodischen Spannungsantwortfunktion liegt genau bei $\vec{B} = 0$ das globale absolute Minimum dieser Spannungsantwortfunktion. In Fig. 18b ist eine typische Spannungsantwortfunktion einer Serienschaltung für $N = 100$ Netzwerkzellen $a_1$ bis $a_{100}$ und sehr großer Periode dargestellt.

Solche Ausführungen besitzen den Vorteil, dass sich bedingt durch die Serienschaltung die Spannungsantwortfunktionen der einzelnen Netzwerkzellen addieren. Dadurch entsteht ein Quanten-Interferenz-Filter mit einem sehr großen Spannungshub, der bis in den Bereich mehrerer mV oder gar V kommen kann. Im Gegensatz zur Parallelschaltung ergibt sich dabei jedoch keine Verminderung der Breite der Spannungsantwortfunktion (Varianz) um $\vec{B} = 0$ im Vergleich zu konventionellen zwei-Kontakt-SQUIDs. Da der Abstand benachbarter Netzwerkschlaufen in Serienanordnungen jedoch beliebig gewählt werden kann, ohne die Quanteninterferenzbedingung zu verletzen, können mit solchen Anordnungen die parasitären gegenseitigen Induktivitäten minimiert werden. Zudem können Serienschaltungen bei der Fertigung technisch bedingte Vorteile haben. Insbesondere ist eine erhöhte Packungsdichte möglich, was bei der Integration der Schaltungen auf einem Chip von Vorteil sein kann.

Die theoretische Beschreibung von Serien-SQIFs kann mit Hilfe von Gleichung 8 erfolgen, da ein Serien-SQIF die einfachste Realisierung eines zweidimensionalen SQIF-arrays darstellt. Für identische Netzwerkkontakte ist die über einer einzelnen Netzwerkzelle für einen überkritischen Treiberstrom $I_0 > 2i_c$ abfallende mittlere Gleichspannung durch

$$\langle V \rangle_n = i_c\, r_n \sqrt{\left(\frac{I_0}{2\,i_c}\right)^2 - \left|\cos(\pi\frac{\Phi_n}{\Phi_0})\right|^2} \qquad\qquad (9)$$

gegeben, wobei $\Phi_n = \langle\, \vec{B}, \vec{a}_n\, \rangle$ gilt. Die über das gesamte Serienarray abfallende mittlere Gleichspannung $\langle V \rangle$ ergibt sich daraus zu

$$\langle V \rangle = \sum_{n=1}^{N} \langle V \rangle_n \qquad\qquad (10)$$

Zwar kann, bedingt durch die Serienanordnung der Netzwerkzellen $\vec{a}_n$, nicht direkt ein Strukturfaktor wie für die Parallelanordnung definiert werden, durch entsprechende Wahl der Folge $\{\vec{a}_n\}$ ist es jedoch auch hier möglich, den Verlauf der Spannungsantwortfunktion und insbesondere den Mess- bzw. Operationsbereich einzustellen.

Im Ausführungsbeispiel der Fig. 18b etwa wurden die orientierten Flächenelemente $\vec{a}_n$ in einer ebenen Serienanordnung entsprechend der arithmetischen Relation

$$a_n = \frac{n}{N} a_N \qquad\qquad (11)$$

gewählt, wobei $a_n = |\vec{a}_n|$ gilt und $a_N$ die größte Fläche des Serien-SQIF mit $N$ Netzwerkzellen und $2N$ Kontakten bezeichnet. Eine solche Wahl hat z.B. den Vorteil, dass das Maximum der Spannungsantwortfunktion direkt auf das Minimum folgt (vgl. Fig. 18b) und so der Spannungshub maximal wird.

In Fig. 18a ist neben dem Serien-SQIF eine typische Ankoppel und Steuerschaltung schematisch eingezeichnet. Bei entsprechender Auslegung wird durch den Kompensationsstrom $I_{comp}$ am Ort der einzelnen Netzwerkzellen ein magnetisches Kompensationsfeld erzeugt, das ein äußeres Feld und/oder das Feld, das durch den Strom $I_{inp}$ erzeugt wird, kompensiert. Dies ermöglicht den Betrieb des SQIF im extrem empfindlichen Nullabgleichmodus. Der Strom $I_{inp}$ ist dabei etwa der input-Strom einer pick-up-loop- oder einer anderen Signalquelle.

Serien-SQIFs können auch deshalb von großem Vorteil sein, weil das Eigenrauschen der Schaltung, etwa bei ihrer Verwendung als (Strom-) Verstärker, nur proportional zu $\sqrt{N}$ anwächst, während der Spannungshub proportional zu $N$ anwächst. Dies ist deshalb der Fall, weil das Spannungsrauschen der unterschiedlichen Netzwerkzellen, bzw. der Josephsonkontakte in diesen Zellen, nicht korreliert ist (reine Stromkopplung), und sich daher nur inkohärent überlagert. Mit Serien-SQIFs oder allgemeinen SQIF-Arrays lassen sich dadurch etwa extrem rauscharme Verstärker realisieren. Eine typische Strom-Spannungskennlinie eines solchen Verstärkerbauteils, das durch einen SQIF realisiert werden kann, ist in Fig. 18c dargestellt. Je nach Auslegung des SQIF können in diesem Operationsmodus auch sehr kleine Ströme ($<10^{-12}A$) detektiert bzw. verstärkt werden. Weitere Vorteile solcher Verstärkerbauteile sind ihre sehr schnellen Schaltzeiten und ihre Anwendbarkeit bis zu sehr hohen Frequenzen.

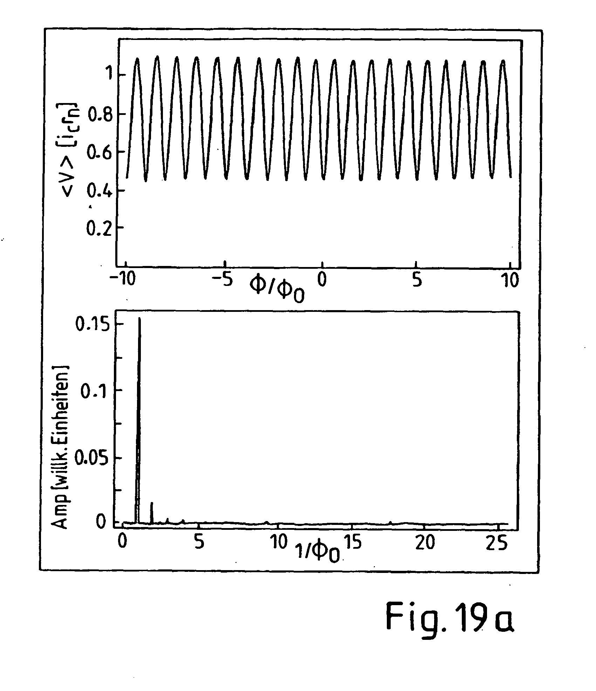

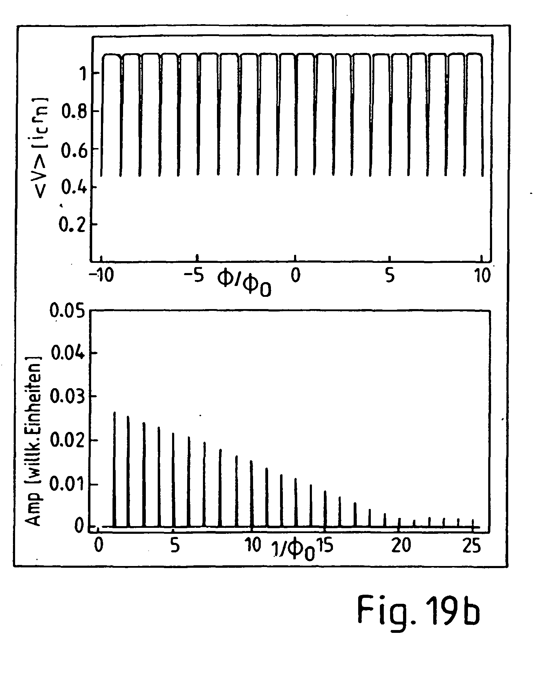

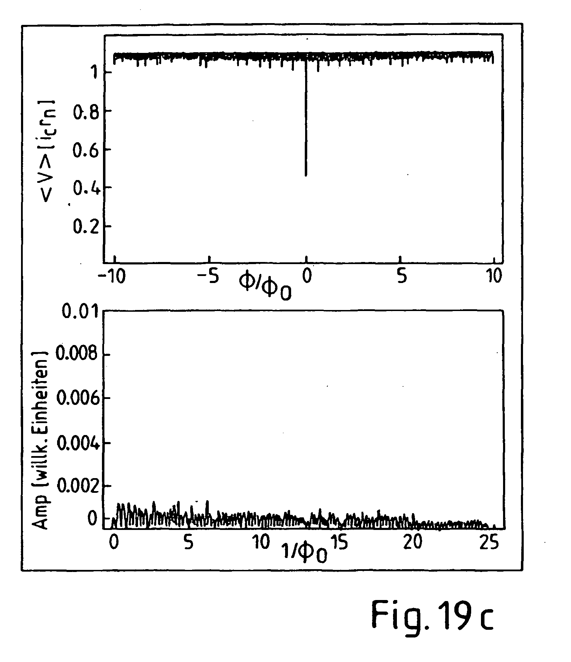

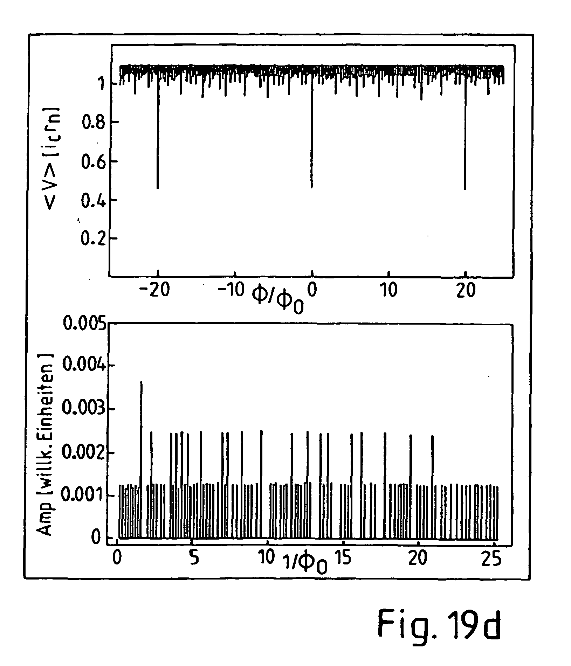

Die Periodizitätseigenschaften der Spannungsantwortfunktion sind ein wesentliches Merkmal von SQIFs. Das Frequenzspektrum der Spannungsantwortfunktionen von SQIFs in Bezug auf den magnetischen Fluss unterscheidet sich daher eindeutig von konventionellen SQUID-Interferometern. Dieser Sachverhalt ist in den Fig. 19a bis 19d anhand von typischen Frequenzspektren von SQUIDs (Fig. 19a und 19b) und von SQIFs (Fig. 19c und 19d) dargestellt.

Fig. 19a zeigt im oberen Bild die typische Spannungsantwortfunktion eines herkömmlichen SQUID. Die $\langle V(\Phi) \rangle$-Kurve ist periodisch mit der Periode $\Phi_0$. Das zugehörige Frequenzspektrum im unteren Bild der Fig. 19a zeigt dementsprechend eine bei weitem dominierende Amplitude bei $1/\Phi_0$. Da die Spannungsantwortfunktion eines SQUID nicht harmonisch ist (vgl. G1.8), treten zusätzlich noch höhere harmonische Moden bei $2\Phi_0$ und $3\Phi_0$ auf, die jedoch lediglich eine sehr kleine Amplitude besitzen. Das Frequenzspektrum herkömmlicher SQUIDs wird damit vom $\Phi_0$-periodischen Beitrag dominiert. Wie Fig. 19b zeigt, ist dies auch bei Mehrschlaufenanordnungen, welche aus identischen Netzwerkzellen aufgebaut sind, der Fall, und zwar unabhängig davon, ob es sich um Serienanordnungen oder Parallelanordnungen identischer SQUID-Schlaufen handelt. Auch bei Parameterimperfektionen oder geometrischen Imperfektionen zeigen dem Stand der Technik entsprechende Quanten-Interferometer immer ein diskretes Frequenzspektrum, das vom $\Phi_0$-periodischen Beitrag dominiert wird. Bei Imperfektionen zusätzlich auftreten kann lediglich ein zusätzliches kontinuierliches Spektrum, das von den Imperfektionen herrührt und von der Art der Imperfektionen abhängt.

Quanten-Interferenz-Filter hingegen besitzen keinen dominanten $\Phi_0$-periodischen Beitrag im Frequenzspektrum ihrer Spannungsantwortfunktionen. Dieser Sachverhalt ist in Fig. 19c und Fig. 19d dargestellt. Die Frequenzspektren in den Fig. 19a bis 19c (untere Bilder) sind in den jeweils gleichen willkürlichen Einheiten aufgetragen, so dass ein direkter Vergleich möglich ist. Die Spannungsantwort und das zugehörige Frequenzspektrum eines Quanten-Interferenz-Filters, welche keine Periodizität besitzt, ist in Fig. 19c gezeigt. Das Spektrum ist praktisch kontinuierlich, ein diskretes Spektrum existiert nicht. Insbesondere existiert kein signifikanter $\Phi_0$ periodischer Beitrag. Die Amplituden des praktisch kontinuierlichen Spektrums sind um zwei bzw. eine Größenordnung kleiner als bei den herkömmlichen Anordnungen nach Fig. 19a bzw. Fig. 19b. In Fig. 19d ist die Spannungsantwortfunktion und das zugehörige Spektrum eines Quanten-Interferenz-Filters dargestellt, welcher eine technisch bedingte Periodizität besitzt. Die Spannungsantwortfunktion hat die Eigenschaft, dass ihre Periode sehr viel größer als $\Phi_0$ ist und das Frequenzspektrum besitzt einen diskreten Anteil mit einer sehr kleinen Amplitude bei der Periode $\Phi_0$. Diese Amplitude bei der Periode $\Phi_0$ ist nicht signifikant und liefert jedenfalls keinen dominanten Beitrag zum Frequenzspektrum. Das diskrete Spektrum ist zudem wiederum dadurch ausgezeichnet, dass dessen Amplituden im Vergleich zu den herkömmlichen Anordnungen um ein bis zwei Größenordnungen kleiner sind.

Die Frequenzspektren der Quanten-Interferenz-Filter sind im Hinblick auf den $\Phi_0$-periodischen Beitrag des Frequenzspektrums robust. Parameterimperfektionen oder geometrische Imperfektionen verändern die oben beschriebenen qualitativen Eigenschaften der Anordnungen nicht.

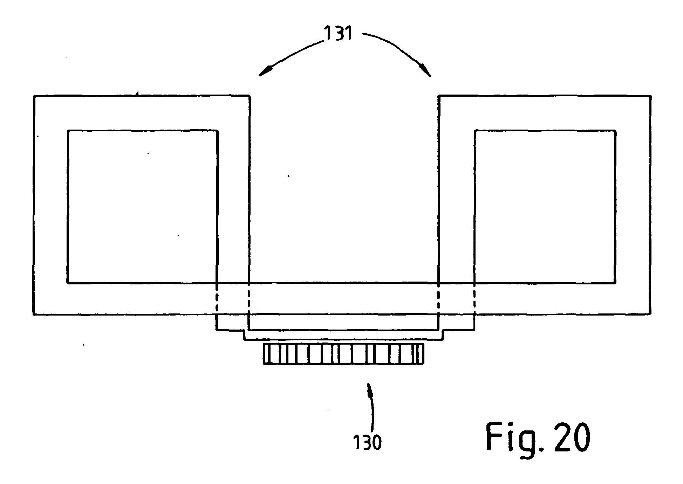

In Fig. 20 ist ein Ausführungsbeispiel eines ebenen SQIF 130 schematisch dargestellt, das mit einer supraleitenden Einkoppelschlaufe (pick-up-loop) versehen ist. Solche Einkoppelschlaufen verstärken das primäre magnetische Feld, indem sie den durch dieses Feld in ihrem Innern erzeugten Fluss nach außen verdrängen. Solche Vorrichtungen haben den Vorteil, dass durch eine geeignete Anordnung das primäre magnetische Feld am Ort des SQIF stark verstärkt werden kann. Ein weiterer Vorteil von SQIFs besteht darin, dass die Gesamtfläche von SQIFs so ausgelegt werden kann, dass die Impedanz-Fehlanpassung zwischen pick-up-loop und SQIF minimiert wird. Die Empfindlichkeit und die Auflösung von SQIFs kann durch solche Vorrichtungen erheblich gesteigert werden. Anstatt eines pick-up-loop können auch supraleitende Flächen (sog. washer) verwendet werden, welche ebenfalls zu den genannten Vorteilen führen. Auch die Ankopplung einer Gradiometerschlaufe ist möglich und führt zu den genannten Vorteilen bei der Messung von Magnetfeldgradienten. Bei der Detektion zeitveränderlicher elektromagnetischer Felder sind geeignet ausgelegt supraleitende Einkoppelschlaufen ebenfalls von Vorteil, da sie gleichzeitig als Empfangsantennen dienen können.

**Patentansprüche**

1. Magnetometer mit geschlossenen supraleitenden eine Stromschleife bildende Zellen (23, 24, 26), die jeweils mehrere, vorzugsweise zwei, Josephsonkontakte (28, 29) enthalten, wobei die Zellen (23, 24, 25, 26) einen supraleitenden Quanten-Interferenz-Filter (1, 9, 27) bilden, bei welchem wenigstens drei dieser Zellen supraleitend und/ oder nicht supraleitend in Verbindung stehen, die Kontakte der wenigstens drei Zellen derart bestrombar sind, dass jeweils über mindestens zwei Kontakte einer Zelle eine zeitveränderliche Spannung abfällt, deren zeitliches Mittel nicht verschwindet, und wobei die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass die Spannungsantwortfunktion in Bezug auf den magnetischen Fluss keine Periodizität mit der Periode $\Phi_0$ besitzt, so dass das Frequenzspektrum der Spannungsantwortfunktion in Bezug auf den magnetischen Fluss keinen signifikanten $\Phi_0$-periodischen Anteil besitzt, oder dass, falls ein diskretes Frequenzspektrum existiert, der Beitrag des $\Phi_0$-periodischen Anteils des diskreten Frequenzspektrums im Vergleich zu den nicht $\Phi_0$-periodischen Anteilen des diskreten Frequenzspektrums nicht dominant ist, **dadurch gekennzeichnet, dass** eine Elektronikeinheit vorgesehen ist, dass die wenigstens drei Zellen derart ausgestaltet sind, dass bei einem vorhandenen magnetischen Feld die in den Zellen fließenden Abschirmströme in der Mehrzahl der wenigstens drei Zellen keinen magnetischen Fluss erzeugen, der größer ist als das elementare Flussquant $\Phi_0$, dass eine mit der Elektronikeinheit (5) verbundene und mit dem supraleitenden Quanten-Interferenz-Filter magnetisch gekoppelte, elektrisch leitende Rückkoppelschlaufe (4, 4a, 4b) vorgesehen ist und dass über die Elektronikeinheit (5) in der Rückkoppelschlaufe (4, 4a, ab) ein Strom derart einstellbar ist, dass am supraleitenden Quanten-Interferenz-Filter eine von der Elektronikeinheit (5) vorgegebene Spannung abfällt und aus der Große des durch die Rückkoppelschlafe (4, 4a, 4b) fließenden Stroms die Stärke des eingekoppeltenmagnetischen Feldes bestimmbar ist.

2. Magnetometer nach Anspruch 1, **dadurch gekennzeichnet, dass** in der-Rückkoppelschlaufe (4, 4a, 4b) ein Strom einstellbar ist, der im supraleitenden Quanten-Interferenz-Filter (1, 9, 27) einen magnetischen Fluss erzeugt, dessen Betrag mindestens dem Betrag eines magnetischen Flusses entspricht, der durch ein von außen in dem supraleitendem Quanten-Interferenz-Filter (1, 9, 27) eingekoppeltes magnetisches Feld erzeugt wird.

3. Magnetometer nach Anspruch 1 oder 2, **dadurch gekennzeichnet, dass** die Elektronikeinheit (5) für die Realisierung einer Suchfunktion Mittel zur Einstellung des durch den Strom in der Rückkoppelschlaufe (4, 4a) erzeugten magnetischen Feldes umfasst, wobei das magnetische Feld derart veränderbar ist, dass der im Operationsbereich liegende Arbeitspunkt des supraleitenden Quanten-Interferenz-Filters (1, 9, 27) automatisch auffindbar ist.

4. Magnetometer nach Anspruch 3, **dadurch gekennzeichnet, dass** die Mittel zur Einstellung des magnetischen Feldes eine vergleichsweise schnell durchfahrbare Rampe für den Strom durch die Rückkoppelschlaufe (4, 4a, 4b) umfassen.

5. Magnetometer nach einem der vorhergehenden Ansprüche, **dadurch gekennzeichnet, dass** zur Einkoppelung des zu messenden magnetischen Feldes von außen in den supraleitenden Quanten-Interferenz-Filter (1, 9, 27) eine zusätzliche supraleitende Struktur (2, 3, 6, 11, 12, 14, 16, 17, 18, 21, 22) vorgesehen ist.

6. Magnetometer nach einem der vorhergehenden Ansprüche, **dadurch gekennzeichnet, dass** die supraleitende Struktur (2, 3, 6, 11, 12, 14, 16, 17, 18, 21, 22) derart ausgelegt ist, dass sie das einzukoppelnde Feld fokussiert.

7. Magnetometer nach einem der vorhergehenden Ansprüche, **dadurch gekennzeichnet, dass** der supraleitende Quanten-Interferenz-Filter und die zusätzliche supraleitende Einkoppelstruktur (2, 3, 6, 11, 12, 14, 16, 17, 18, 21, 22) auf separaten Trägern (15, 19) angeordnet sind, die magnetisch und/oder elektrisch gekoppelt sind.

8. Magnetometer nach Anspruch 7, **dadurch gekennzeichnet, dass** zur magnetischen Koppelung der separaten Träger (15, 19) ein Flusstransformator (18) vorgesehen ist.

9. Magnetometer nach Anspruch 7 oder 8, **dadurch gekennzeichnet, dass** der supraleitende Quanten-Interferenz-Filter (1) auf der Oberseite eines ersten Trägers (15) und eine flussfokussierende Struktur (16, 17) auf der Unterseite eines zweiten Trägers (19) aufgebracht sind und die beiden Träger (15, 19) übereinander liegen.

10. Magnetometer nach einem der vorhergehenden Ansprüche, **dadurch gekennzeichnet, dass** Mittel auf der Basis einer supraleitenden Struktur (21, 22) vorgesehen sind, mit welchen eine oder mehrere räumliche Ableitungen eines zu messenden magnetischen Feldes in den supraleitenden Quanten-Interferenz-Filter (1) einkoppelbar sind.

11. Magnetometer nach einem der vorhergehenden Ansprüche, **dadurch gekennzeichnet, dass** das Magnetometer (8) mehrere SQIFs (9) enthält, welche einzeln oder in Gruppen von einer einzelnen oder mehreren Elektronikeinheiten (5) und durch eine einzelne oder mehrere Rückkoppelschlaufen (4) getrennt oder gemeinsam steuerbar sind.

**Claims**

1. Magnetometer with closed superconducting cells (23, 24, 26) forming a current loop, which each contain several, preferably two Josephson junctions (28, 29), wherein the cells (23, 24, 25, 26) form a superconducting quantum-interference-filter (1, 9, 27), In which at least three of said cells are connected in a superconducting and/or non-superconducting manner, the junctions of the at least three cells can be charged with current such that via at least two contacts of a cell a time-variable voltage drops, the timing means of which does not disappear, and wherein the at least three cells are designed to be geometrically different such that the magnetic fluxes surrounded by the cells with an existing magnetic field differ from one another such that the voltage response function in reference to the magnetic flux has no periodicity with period $\Phi_0$, so that the frequency spectrum of the voltage response function with reference to the magnetic flux has no significant $\Phi_0$-periodic portion, or if there is a discrete frequency spectrum the contribution of the $\Phi_0$ periodic portion of the discrete frequency spectrum compared to the non $\Phi_0$ periodic portions of the discrete frequency spectrum is not dominant, **characterised in that** an electronic unit is provided, **In that** the at least three cells are designed such that with an existing magnetic field the screening currents flowing into the cells in the majority of the at least three cells do not generate a magnetic flux, which is greater than the elementary flux quantum $\Phi_0$, **in that** an electricity conducting feedback loop (4, 4a, 4b) connected to the electronic unit (5) and coupled magnetically with the superconducting quantum-Interference filter is provided, and **In that** by means of the electronic unit (5) in the feedback loop (4, 4a, ab) a current can be adjusted, such that at the superconducting quantum interference filter a voltage defined by the electronic unit (5) falls and from the size of the current flowing through the feedback loop (4, 4a, 4b) the strength of the coupled magnetic field can be determined.

2. Magnetometer according to claim 1, **characterised in that** in the feedback loop (4, 4a, 4b) a current can be adjusted, which in the superconducting quantum interference filter (1, 9, 27) generates a magnetic flux, the amount of which corresponds to at least the amount of a magnetic flux, which is generated by a magnetic field coupled from the outside into the superconducting quantum interference filter (1, 9, 27).

3. Magnetometer according to claim 1 or 2, **characterised in that** the electronic unit (5) for performing a search function comprises means for adjusting the magnetic field generated by the current In the feedback loop (4, 4a), wherein the magnetic field can be changed such that the operating point of the superconducting quantum interference filter (1, 9, 27) in the operational range can be found automatically.

4. Magnetometer according to claim 3, **characterised in that** the means for adjusting the magnetic field comprise a comparatively rapidly traversable ramp for the current through the feedback loop (4, 4a, 4b).

5. Magnetometer according to one of the preceding claims, **characterised in that** for coupling the magnetic field to be measured from the outside into the superconducting quantum interference filter (1, 9, 27) an additional superconducting structure (2, 3, 6, 11, 12, 14, 16, 17, 18, 21, 22) is provided.

6. Magnetometer according to one of the preceding claims, **characterised in that** the superconducting structure (2, 3, 6.11, 12, 14, 16, 17, 18, 21, 22) is set up so that it focuses the field to be coupled.

7. Magnetometer according to one of the preceding claims, **characterised in that** the superconducting quantum interference filter and the additional superconducting coupling structure (2, 3, 6, 11, 12, 14, 18, 17, 18, 21, 22) are arranged on separate carriers (15, 19) which are coupled magnetically and/or electrically.

8. Magnetometer according to claim 7, **characterised in that** for the magnetic coupling of the separate carriers (15, 19) a flux transformer (18) is provided.

9. Magnetometer according to claim 7 or 8, **characterised in that** the superconducting quantum interference filter (1) is attached onto the upper side of a first carrier (15) and a flux-focussing structure (16, 17) is attached onto the lower side of a second substrate (19) and both substrates (15, 19) lle on top of one another.

10. Magnetometer according to one of the preceding claims, **characterised In that** means are provided on the base of a superconducting structure (21, 22), by means of which one or more spatial derivations of a magnetic field to be measured can be coupled into the superconducting quantum-interference filter (1).

11. Magnetometer according to one of the preceding claims, **characterised in that** the magnetometer (8) contains several SQIFs (9) which are arranged separately or controlled jointly in groups by one individual or several electronic units (5) and by one individual or several feedback loops (4).

**Revendications**

1. Magnétomètre ayant des cellules (23, 24, 26), supraconductrices, fermées constituant une boucle de courant, et comportant respectivement plusieurs, et de préférence deux contacts de Josephson (28, 29),

   * les cellules (23, 24, 25, 26) formant un filtre à interférences quantiques, supraconducteur (1, 9, 27) dans lequel au moins trois des cellules sont en liaison supraconductrice et/ou non-supraconductrice, les contacts au moins des trois cellules étant alimentés de façon que respectivement au moins deux contacts d'une cellule, donnent une tension variable dans le temps et dont la moyenne dans le temps ne disparait pas, et
   * au moins les trois cellules sont différentes les unes des autres du point de vue géométrique de façon que les flux magnétiques dans les cellules sous l'effet d'un champ magnétique se distinguent de sorte que la fonction de réponse en tension par rapport au flux magnétique ne présente pas de périodicité ayant une période $\Phi_0$ de sorte que le spectre en fréquence de la fonction de réponse en tension par rapport au flux magnétique ne possède pas de composantes périodiques $\Phi_0$, significatives, ou
   * qu'au cas où il existerait un spectre de fréquence discret, la participation de la composante périodique $\Phi_0$ de ce spectre de fréquence discret par comparaison aux composantes non-périodiques $\Phi_0$ du spectre de fréquence discret, ne soit pas dominante,

   **caractérisé en ce qu'**

   - il est prévu une unité électronique (5),
   - au moins trois cellules sont réalisées pour qu'en présence d'un champ magnétique, les courants de protection traversant les cellules ne génèrent dans la majorité au moins des trois cellules, aucun flux magnétique supérieur au flux quantique élémentaire $\Phi_0$,
   - il est prévu une boucle de réaction (4, 4a, 4b) électroconductrice, reliée à l'unité électronique (5) et couplée magnétiquement au filtre à interférences quantiques supraconducteur, et
   - l'unité électronique (5) règle un courant dans la boucle de réaction (4, 4a, 4b) de façon à recueillir sur le filtre à interférence quantiques, supraconducteur, une tension prédéfinie par l'unité électronique (5) et qu'à partir de l'amplitude du courant traversant la boucle de réaction (4, 4a, 4b), on détermine l'intensité du champ magnétique induit par couplage.

2. Magnétomètre selon la revendication 1,
   **caractérisé en ce qu'**
   un courant est réglé dans la boucle de réaction (4, 4a, 4b) qui génère un flux magnétique dans le filtre à interférences quantique supraconducteur (1, 9, 27), flux dont l'amplitude correspond au moins à l'amplitude d'un flux magnétique généré par un champ magnétique injecté de l'extérieur dans le filtre à interférence quantiques, supraconducteur (1, 9, 27).

3. Magnétomètre selon la revendication 1 ou 2,
   **caractérisé en ce que**
   pour réaliser une fonction de recherche, l'unité électronique (5) comporte des moyens pour régler le champ magnétique généré par le courant dans la boucle de réaction (4, 4a),
   le champ magnétique étant variable de façon à trouver automatiquement le point de fonctionnement qui se situe dans la plage opérationnelle du filtre à interférence quantiques, supraconducteur (1, 9, 27).

4. Magnétomètre selon la revendication 3,

**caractérisé en ce que**
les moyens de réglage du champ magnétique comportent une rampe qui se parcourt relativement rapidement pour le courant à travers la boucle de réaction (4, 4a, 4b).

5. Magnétomètre selon l'une des revendications précédentes, **caractérisé en ce que**
une structure supraconductrice supplémentaire (2, 3, 6, 11, 12, 14, 16, 17, 18, 21, 22) assure le couplage du champ magnétique à mesurer à partir de l'extérieur dans le filtre à interférence quantiques, supraconducteur (1, 9, 27).

6. Magnétomètre selon l'une des revendications précédentes,
**caractérisé en ce que**
la structure supraconductrice (2, 3, 6, 11, 12, 14, 16, 17, 18, 21, 22), focalise le champ à injecter.

7. Magnétomètre selon l'une des revendications précédentes,
**caractérisé en ce que**
le filtre à interférences quantiques supraconducteur et la structure de couplage supraconductrice supplémentaire (2, 3, 6, 11, 12, 14, 16, 17, 18, 21, 22), sont sur des supports séparés (15, 19) à couplage magnétique et/ou électrique.

8. Magnétomètre selon la revendication 7,
**caractérisé en ce qu'**
un transformateur de flux (18) assure le couplage magnétique du support séparé (15, 19).

9. Magnétomètre selon la revendication 7 ou 8,
**caractérisé en ce que**
le filtre à interférences quantiques (1), supraconducteur, se situe sur le côté supérieur d'un premier support (15) et une structure de focalisation de flux (16, 17) se trouve sur le côté inférieur d'un second porteur (19) et deux porteurs (15, 19) sont superposés.

10. Magnétomètre selon l'une des revendications précédentes,
**caractérisé par**
des moyens à base d'une structure supraconductrice (21, 22) permettant d'injecter une ou plusieurs dérivées dans l'espace, d'un champ magnétique à mesurer, dans le filtre à interférences quantiques supraconducteur (1).

11. Magnétomètre selon l'une des revendications précédentes,
**caractérisé en ce que**
le magnétomètre (8) comporte plusieurs SQIF (9) commandés séparément ou en groupe par une unité électronique séparée ou plusieurs unités électroniques (5) et par une ou plusieurs boucles de réaction (4).

Fig. 1

Fig. 2

Fig. 3

Fig. 4

Fig. 5

Fig.6a

Fig.6b

Fig. 7

Fig. 8

108    111    105

107    110    112    113    103    101

109    106

Fig. 9a

108a 109a    110a    111a    113a 105
107a                    112a    114a

104    102

106    104

Fig. 9b

Fig.10d

Fig.10e

Fig.10f

Fig.10a

Fig.10b

Fig.10c

EP 1 387 178 B1

Fig.10

33

Fig.11

Fig. 12 a

Fig. 12 b

Fig. 12 c

EP 1 387 178 B1

Fig. 12 d

36

Fig.13

Fig. 14

Fig. 15

Fig. 16

Fig.17a

Fig.17b

Fig.17c

Fig.18 a

Fig.18 b

Fig.18 c

Fig. 19 a

Fig. 19b

Fig. 19 c

Fig. 19d

131

130

Fig. 20

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 10043657 A1

### In der Beschreibung aufgeführte Nicht-Patentliteratur

- *Reviews of Modern Physics,* Juli 1984, vol. 56 (3), 431-459